(19) Europäisches Patentamt / European Patent Office / Office européen des brevets

(11) **EP 3 084 843 B1**

(12) **FASCICULE DE BREVET EUROPEEN**

(45) Date de publication et mention de la délivrance du brevet:
**27.01.2021 Bulletin 2021/04**

(21) Numéro de dépôt: **14825129.1**

(22) Date de dépôt: **17.12.2014**

(51) Int Cl.:
*H01L 31/109* (2006.01)   *H01L 31/105* (2006.01)
*H01L 31/0304* (2006.01)   *H01L 31/0232* (2014.01)
*G02B 6/12* (2006.01)

(86) Numéro de dépôt international:
**PCT/EP2014/078329**

(87) Numéro de publication internationale:
**WO 2015/091709 (25.06.2015 Gazette 2015/25)**

(54) **ELÉMENT DE DÉTECTION QUANTIQUE À FAIBLE BRUIT ET PROCÉDÉ DE FABRICATION D'UN TEL ÉLÉMENT DE PHOTODÉTECTION**

QUANTENDETEKTIONSELEMENT MIT GERINGEM RAUSCHEN UND VERFAHREN ZUR HERSTELLUNG SOLCH EINES LICHTDETEKTIONSELEMENTS

QUANTUM DETECTION ELEMENT WITH LOW NOISE AND METHOD FOR MANUFACTURING SUCH A PHOTODETECTION ELEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2013 FR 1362842**

(43) Date de publication de la demande:
**26.10.2016 Bulletin 2016/43**

(73) Titulaires:
• **Centre National de la Recherche Scientifique (C.N.R.S.)**
**75794 Paris Cedex 16 (FR)**
• **Office National d'Etudes et de Recherches Aérospatiales (ONERA)**
**91120 Palaiseau (FR)**

(72) Inventeurs:
• **PORTIER, Benjamin**
**91200 Athis Mons (FR)**
• **VERDUN, Michaël**
**F-91400 Orsay (FR)**
• **HAIDAR, Riad**
**F-75012 Paris (FR)**
• **PELOUARD, Jean-Luc**
**F-75020 Paris (FR)**
• **PARDO, Fabrice**
**F-94400 Vitry-sur-seine (FR)**

(74) Mandataire: **Marks & Clerk France**
**Immeuble "Visium"**
**22, avenue Aristide Briand**
**94117 Arcueil Cedex (FR)**

(56) Documents cités:
**US-A- 5 455 421**   **US-A- 5 818 066**
**US-A1- 2013 228 887**

• **TAN I-H ET AL: "MODELING AND PERFORMANCE OF WAFER-FUSED RESONANT-CAVITY ENHANCED PHOTODETECTORS", IEEE JOURNAL OF QUANTUM ELECTRONICS, IEEE SERVICE CENTER, PISCATAWAY, NJ, USA, vol. 31, no. 10, octobre 1995 (1995-10), pages 1863-1875, XP000536242, ISSN: 0018-9197, DOI: 10.1109/3.466063**
• **XIAOFENG DUAN ET AL: "Monolithically Integrated Photodetector Array With a Multistep Cavity for Multiwavelength Receiving Applications", JOURNAL OF LIGHTWAVE TECHNOLOGY, IEEE SERVICE CENTER, NEW YORK, NY, US, vol. 27, no. 21, novembre 2009 (2009-11), pages 4697-4702, XP011270011, ISSN: 0733-8724, DOI: 10.1109/JLT.2009.2026492**

- S. COLLIN ET AL: "Light confinement and absorption in metal-semiconductor-metal nanostructures", PROCEEDINGS OF SPIE: QUANTUM DOTS, NANOPARTICLES, AND NANOCLUSTERS II, vol. 5734, 4 avril 2005 (2005-04-04), pages 1-12, XP040200754, DOI: 10.1117/12.597202

**Description**

ETAT DE L'ART

**Domaine technique de l'invention**

La présente invention concerne un élément de photodétection quantique à très faible bruit et un procédé de fabrication d'un tel élément de photodétection. L'invention s'applique notamment à la conception de photodétecteurs dans l'infrarouge à très bonne sensibilité.

**Etat de l'art**

Un détecteur optique convertit un rayonnement optique en signal électrique. Cette conversion photon-électron peut être indirecte: dans le cas des détecteurs thermiques par exemple, l'absorption de lumière se traduit par une élévation de température d'un matériau absorbant qui est ensuite convertie en signal électrique. Les détecteurs photoniques (ou quantiques) mettent enjeu au contraire une création directe de charges électriques qui peuvent être soit éjectées (effet photoémissif) soit libérées au sein du matériau photosensible (cas des matériaux semi-conducteurs).

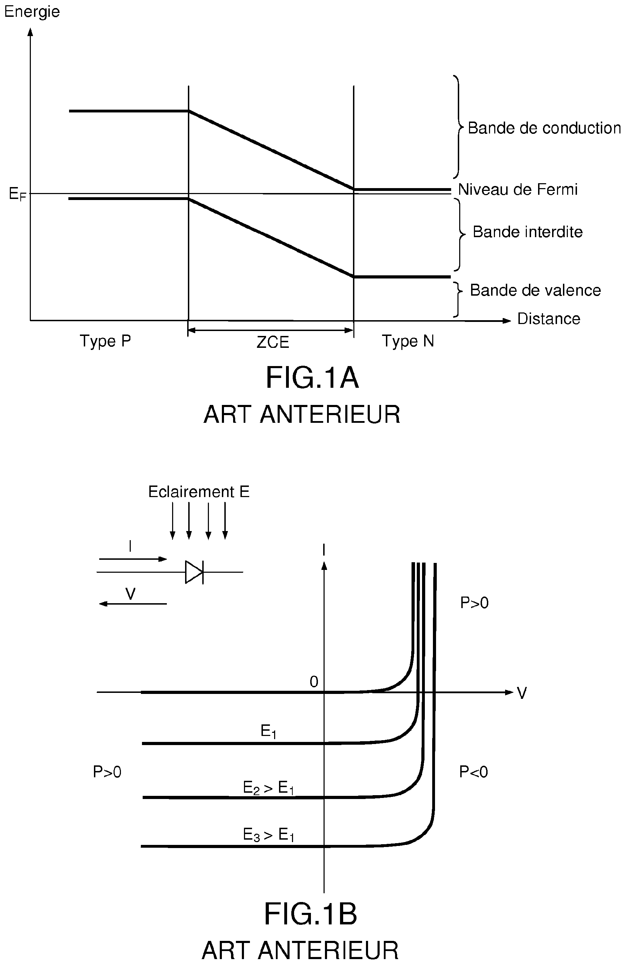

Parmi les détecteurs à semi-conducteurs, on distingue notamment les photorésistances et les photodiodes. Les photorésistances (ou LDR: Light Dépendant Resistor) comprennent une couche en matériau semi-conducteur ; elles se comportent comme des résistances qui laissent passer un courant électrique plus ou moins grand en fonction de l'éclairement lumineux. Les photodiodes sont des diodes à jonction traversées à polarisation électrique donnée par un courant électrique fonction de l'éclairement lumineux. Elles comprennent par exemple un semi-conducteur dopé de type P et un semi-conducteur dopé de type N qui forment une jonction à leur interface (jonction dite PN). Le dopage de type N est réalisé par l'introduction dans le cristal d'impuretés donatrices d'électrons qui augmentent la densité de charges négatives (électrons). Le dopage de type P est réalisé grâce à des impuretés acceptrices d'électrons qui augmentent la densité de charges positives (trous). La figure 1A montre le diagramme d'énergie des électrons dans une jonction PN. Au voisinage de la jonction, il existe une zone de déplétion (absence de porteurs libres) également appelée zone de charge d'espace (ZCE). Les photons d'énergie supérieure à l'énergie de la bande interdite du semi-conducteur (« gap »), c'est-à-dire de longueur d'onde inférieure à une longueur d'onde dite de coupure ($\lambda_c$), sont absorbés et induisent le passage d'un électron de la bande de valence à la bande de conduction qui se traduit par l'apparition d'une paire de charges mobiles supplémentaires : un électron dans la bande de conduction et un trou dans la bande de valence. Dans la zone de charge d'espace, sous l'action du champ électrique qui règne dans cette zone, le trou sera accéléré vers la zone de type P et l'électron vers la zone N, chacun d'eux s'ajoutant aux porteurs majoritaires de ces zones. Il en résulte une séparation de la paire électron-trou et un courant électrique circulant dans le dispositif de la zone de type N vers la zone de type P, le photo-courant, qui vient en augmentation du courant inverse de la diode. Ce schéma est parfois amélioré par l'ajout entre les deux zones d'une couche non-intentionnellement dopée (dite par abus de langage « Intrinsèque ») permettant d'augmenter l'épaisseur de la ZCE de façon à la rendre plus proche de la longueur d'absorption des photons dans le semi-conducteur (jonction « PIN »).

La figure 1B montre la caractéristique courant/tension d'une photodiode éclairée par un flux lumineux E pouvant prendre plusieurs valeurs $E_1$, $E_2$, $E_3$ telles que $E_1 < E_2 < E_3$. L'intensité I correspond à l'intensité du courant électrique qui la traverse en fonction de la tension V à ses bornes. Comme l'illustre la figure 1B, la particularité d'une photodiode est que sa caractéristique courant/tension dépend du flux lumineux qu'elle reçoit. En l'absence d'éclairement, la caractéristique est celle d'une diode à jonction avec en particulier un courant nul pour une tension appliquée nulle. Lorsque le flux lumineux augmente, on observe une augmentation du courant vers les intensités négatives, en particulier pour les tensions négatives. D'après les conventions choisies pour l'orientation de I et V, si le produit P=I*V est positif, le dipôle reçoit de l'énergie et fonctionne en récepteur. Si le produit est négatif, le dipôle fournit de l'énergie ; il se comporte comme un générateur. Le quadrant générateur correspond au domaine photovoltaïque.

Quand le dipôle fonctionne en récepteur, on caractérise le dispositif par sa détectivité :

$$D^* \propto \sqrt{\frac{1}{2 j_{obs}}} \, \eta_{ext}$$

avec $\eta_{ext}$ le rendement quantique du dispositif et $j_{obs}$ la densité de courant d'obscurité, le courant d'obscurité étant défini comme le courant électrique du photodétecteur en l'absence d'éclairement lumineux. Les principales sources de courant d'obscurité sont d'une part des sources intrinsèques, comme le courant de diffusion des porteurs minoritaires et le courant de génération-recombinaison radiative et non radiative des charges, et d'autre part des sources liées au procédé de fabrication, comme les courants de recombinaison non-radiative sur les défauts du semi-conducteur (courant dit SRH) particulièrement intense au voisinage des surfaces ou des interfaces.

Le courant de diffusion des porteurs minoritaires est proportionnel au gradient de leur densité, lui-même imposé par les conditions aux limites en bordure de la ZCE d'une part et du contact électrique d'autre part. Lorsque les électrons ou les trous ne sont pas distribués uniformément dans le semi-conducteur, leur mouvement s'effectue dans un sens qui tend à uniformiser leur distribution spatiale. Dans une jonction PN, la distribution des porteurs minoritaires dans les zones dopées n'est pas uniforme, d'où une diffusion de ces porteurs. Le courant qui en résulte s'appelle le courant de diffusion.

Il a été mis en évidence dans l'article de S.R. Forrest et al. en 1980 (voir « In0,53Ga0,47As photodiodes with dark current limited by generation-recombination and tunneling » Appl.Phys.Lett. 37(3), 1980) une forte réduction du courant de diffusion au moyen de « couches barrière » en InP dans des hétérojonctions de type InP/InGaAs.

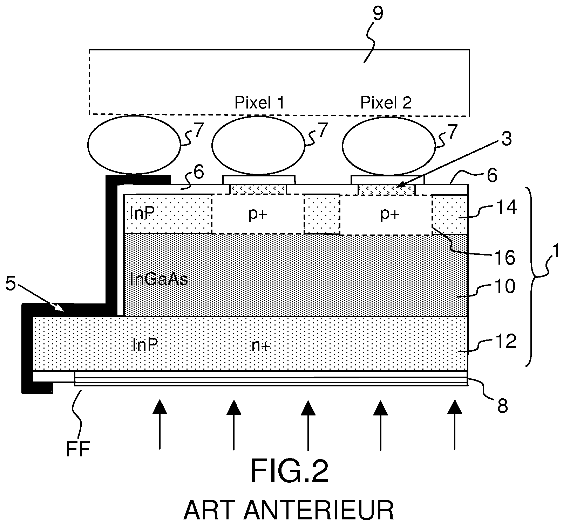

La figure 2 décrit ainsi un détecteur quantique selon l'art antérieur, comprenant une hétérojonction 1 de type PIN composé de trois couches 14, 10, 12 en matériau semi-conducteur, par exemple une hétérojonction de type InP/In-GaAs. La couche 10, par exemple en InGaAs, située entre les couches 14 et 12, par exemple en InP, est une couche en matériau semi-conducteur absorbant dans la bande spectrale d'intérêt et forme la zone I de la jonction PIN. L'épaisseur de la couche absorbante 10 est d'environ 2 $\mu$m ou plus, pour absorber l'ensemble du rayonnement incident. Les couches 14 et 12 situées de part et d'autre de la zone I, présentent des bandes d'énergie interdite supérieures à la bande d'énergie interdite de la zone I, formant ainsi des couches dites « couches barrière » qui permettent de limiter fortement le courant de diffusion dans l'hétérojonction, comme cela a été mis en évidence dans S.R.Forrest et al. Des zones 16 de type P sont obtenues par diffusion ou implantation ionique dans la couche barrière 14. Chaque zone de type P définit ainsi un pixel du détecteur. Des couches de passivation 6 en face arrière permettent de limiter les effets des défauts de cristallinité à l'origine du courant SRH (Shockley-Read-Hall) dans la zone de charge d'espace. Une couche en matériau conducteur 3, par exemple une couche métallique, permet de former au niveau de chaque pixel un contact électrique. Chaque contact électrique 3 est en contact avec un circuit de lecture 9 via une bille d'Indium 7. Le contact électrique 3 représente pour chaque pixel l'anode du circuit électrique formé par l'hétérojonction. La cathode du circuit est formée par un contact déporté 5 en contact électrique avec la couche barrière 12 et permettant le contact avec le circuit de lecture. La couche barrière 12 formant la face avant FF destinée à recevoir le rayonnement incident est recouverte d'une couche antireflet 8 afin de transmettre à l'hétérojonction le maximum du flux optique incident (représenté par des flèches sur la figure 2).

On peut montrer que dans les hétérojonctions à faible courant de diffusion telles que décrites sur la figure 2, le courant de génération-recombinaison devient prédominant.

On dit qu'il y a « génération » lorsqu'un électron occupant un état dans la bande de valence fait une transition vers un état inoccupé de la bande de conduction. C'est un processus qui se produit spontanément à température non-nulle. À l'équilibre thermodynamique, la génération thermique est exactement compensée par un processus antagoniste, appelé « recombinaison » : un électron de la bande de conduction transite vers la bande de valence. Il y a plusieurs processus de génération-recombinaison dans les semi-conducteurs. On distingue habituellement les processus radiatifs et non-radiatifs selon que l'énergie de la paire électron-trou est dissipée par l'émission d'un photon (radiative) ou de phonons (non radiative). Tous ces phénomènes de génération-recombinaison induisent un courant parasite dans la structure, appelé courant de génération-recombinaison.

La problématique de réduction du courant d'obscurité dans une hétérojonction à faible courant de diffusion est toujours d'actualité comme le témoigne l'article de J. A. Trezza et al. en 2011 (Proceedings SPIE, 8012 : 80121Y-80121Y-12, 2011), dans lequel une analyse et une estimation des courants d'obscurité sont détaillées. On montre qu'en polarisation inverse, la densité de courant d'obscurité est proportionnelle au taux de génération-recombinaison des charges et à l'épaisseur de la zone de charge d'espace, dans laquelle ont lieu les phénomènes de génération-recombinaison.

A noter que le processus de génération-recombinaison existe aussi dans les photorésistances, au niveau de la couche en matériau semi-conducteur, créant de la même manière un courant d'obscurité parasite.

Pour réduire le courant d'obscurité, on peut chercher à réduire le taux de recombinaison-génération tout en maintenant faible le courant de diffusion, par exemple en refroidissant le détecteur, ce qui constitue une solution couteuse en énergie, ou en optimisant la structure électronique. On peut également chercher à réduire l'épaisseur de la zone de charge d'espace.

Cependant, la diminution de l'épaisseur de la zone de charge d'espace se traduit également par une diminution de l'absorption du détecteur.

Il est connu d'utiliser des résonateurs optiques pour concentrer l'énergie et compenser la diminution de l'épaisseur de la zone de charge d'espace, dans le domaine de la détection infrarouge (voir par exemple le brevet EP 2 276 072) ou dans le domaine du photovoltaïque (voir par exemple Polman, A., & Atwater, H. A. (2012), 'Photonic design principles for ultrahigh-efficiency photovoltaics', Nature materials, 11(3), 174-177). Les brevets EP 0 807 982 et EP 2 477 231 cherchent également grâce à des structures résonantes à réduire l'épaisseur de la zone active afin de réduire le bruit du dispositif. Aucun de ces documents cependant ne divulgue d'éléments de photodétection permettant une réduction du courant de génération-recombinaison, notamment dans les jonctions à faible courant de diffusion.

Un objet de la présente invention est de réaliser un détecteur ayant une détectivité optimisée grâce à une réduction du courant d'obscurité ; cet objectif est atteint au moyen d'un résonateur optique dont l'agencement particulier permet une diminution drastique des phénomènes de génération-recombinaison.

RESUME DE L'INVENTION

Selon un premier aspect, l'invention concerne un élément de photodétection quantique d'un rayonnement incident dans une bande spectrale centrée autour d'une longueur d'onde centrale $\lambda_0$, tel que défini par l'objet de la revendication 1, présentant entre autres une face avant destinée à recevoir ledit rayonnement, et comprenant :

- un empilement de couches en matériau semi-conducteur formant une jonction PN ou PIN et comprenant au moins une couche en matériau semi-conducteur absorbant de longueur d'onde de coupure $\lambda_c > \lambda_0$, l'empilement de couches en matériau semi-conducteur formant une cavité optique résonante;
- une structure de couplage du rayonnement incident avec la cavité optique pour former :

  ◦ une résonance à la longueur d'onde centrale $\lambda_0$ permettant une absorption supérieure à 80% dans la couche en matériau semi-conducteur absorbant à ladite longueur d'onde centrale;
  ◦ un minimum d'absorption dans la couche en matériau semi-conducteur à la longueur d'onde radiative $\lambda_{rad}$, où la longueur d'onde radiative $\lambda_{rad}$ est la longueur d'onde pour laquelle, à température de fonctionnement, le taux de recombinaison radiative est maximal.

Des contacts électriques permettent la polarisation de l'élément de photodétection.

La longueur d'onde $\lambda_{rad}$, appelée longueur d'onde radiative dans la présente demande, est la longueur d'onde pour laquelle le taux de recombinaison radiative est maximal. Elle vérifie l'inéquation $\lambda_0 < \lambda_{rad} < \lambda_c$. En s'assurant d'une absence de résonance à la longueur d'onde radiative, on s'assure d'une limitation de l'absorption de l'élément de photodétection à $\lambda_{rad}$. On peut alors réduire de façon radicale le courant de génération-recombinaison, l'émissivité variant comme l'absorption, selon la loi de Kirchoff. On peut aussi travailler à une longueur d'onde $\lambda_0$ plus éloignée de la longueur d'onde de coupure en assurant une absorption réduite à la longueur d'onde radiative, la réduction devant être supérieure à $\exp(\Delta E/kT)$ où $\Delta E$ est la variation des énergies correspondant aux longueurs d'onde $\lambda_{rad}$ et $\lambda_o$.

Selon l'invention,

la structure de couplage du rayonnement incident avec la cavité optique est adaptée pour produire un minimum d'absorption dans la couche en matériau semi-conducteur absorbant à la longueur d'onde radiative. Selon une variante, ce minimum d'absorption résulte d'une antirésonance dans la cavité.

Dans les structures de l'art antérieur, la longueur d'onde de coupure est généralement choisie très proche de la longueur d'onde centrale de la bande spectrale de détection afin de limiter le taux de recombinaison radiative et par là, le courant d'obscurité. Selon la présente description, la longueur d'onde de coupure est intentionnellement choisie avec un écart de longueur donné avec la longueur d'onde centrale de la bande spectrale de détection, la cavité optique présentant une non résonance à la longueur d'onde radiative, dont la valeur est comprise strictement entre la longueur d'onde centrale de la bande spectrale de détection et la longueur d'onde de coupure.

Avantageusement, selon une variante, la structure de couplage du rayonnement incident avec la cavité optique est adapté pour réduire l'absorption dans la couche en matériau semi-conducteur absorbant à la longueur d'onde radiative $\lambda_{rad}$, la dite réduction étant supérieure à $\exp(\Delta E/kT)$ où $\Delta E$ est la variation des énergies correspondant aux longueurs d'onde $\lambda_{rad}$ et $\lambda_o$. La réduction de l'absorption est comprise ici par comparaison avec un élément de détection identique dans lequel il n'y a aurait pas de structure de couplage.

Avantageusement, la résonance à la longueur d'onde centrale de la bande spectrale de détection est localisée dans la couche en matériau semi-conducteur absorbant, permettant de limiter l'absorption en surface et sur les interfaces.

Selon l'invention, l'élément de photodétection comprend une couche réflective métallique agencée d'un côté de la cavité optique, opposé au côté supportant la face avant. Selon une variante, la couche réflective métallique sert également de contact électrique pour l'élément de photodétection.

Selon l'invention, la cavité optique résonante est un guide d'onde et la structure de couplage comprend un réseau de couplage en face avant et/ou un réseau de couplage en face arrière, c'est-à-dire du côté de la cavité optique opposé au côté supportant la face avant.

Le(s) réseau(x) de couplage peut (peuvent) être à une ou deux dimensions, formé(s) par une alternance de matériaux diélectrique/diélectrique (les matériaux diélectriques présentant des indices de réfraction avec des parties réelles différentes). Le matériau diélectrique peut être un isolant ou un semi-conducteur.

Le(s) réseau(x) de couplage peut (peuvent) être limité(s) aux dimensions d'un pixel ou être étendu(s) sur un ensemble de pixels.

Dans le cas où la cavité optique est un guide d'onde, la résonance à la longueur d'onde centrale $\lambda_0$ dans la couche en matériau semi-conducteur absorbant est une résonance de mode guidé. Avantageusement, le guide d'onde présente une antirésonance à la longueur d'onde radiative $\lambda_{rad}$ dans la couche en matériau semi-conducteur absorbant, résultant d'interférences destructives conduisant à une absorption quasi-nulle.

L'épaisseur du guide d'onde détermine de nombre de résonances dans le guide. Avantageusement, l'épaisseur du guide d'onde est comprise entre $\lambda_0/8n$ et $\lambda_0/n$, avantageusement entre $\lambda_0/4n$ et $3\lambda_0/4n$, où n est la valeur moyenne des parties réelles des indices de réfraction des couches en matériau semi-conducteur formant le guide d'onde. En choisissant une épaisseur suffisamment grande, on s'assure d'avoir dans la couche en matériau semi-conducteur absorbant au moins une résonance à la longueur d'onde recherchée. En limitant l'épaisseur, on limite le nombre de résonances dans la couche en matériau semi-conducteur absorbant, ce qui permet d'espacer les longueurs d'onde de résonance et de faciliter l'apparition d'un « noeud de résonance » à $\lambda_{rad}$.

Selon une variante, le ou les réseau(x) de couplage comprennent une structure périodique, de période comprise entre $\lambda_0/n$ et $\lambda_0/n_1$, où $n_1$ est la partie réelle de l'indice de réfraction du milieu d'incidence du rayonnement (par exemple l'air). Ces conditions sur la période du ou des réseau(x) permettent de limiter le nombre d'ordres de diffraction dans l'empilement de couches formant le guide d'onde, plus précisément de n'avoir que l'ordre de diffraction 0 dans le milieu incident et les ordres diffractés 0, -1 et +1 dans le guide d'onde, ce qui permet là encore d'espacer les longueurs d'onde de résonance. Cette configuration permet par ailleurs une très bonne tolérance angulaire de l'élément de détection.

Selon un exemple qui n'est pas couvert par l'invention, la structure de couplage comprend des structures « Métal Diélectrique Métal » autrement appelés MDM.

Selon l'invention, l'élément de photodétection comprend un empilement de couches en matériau semi-conducteur formant une hétérojonction de type PN ou PIN, ledit empilement comprenant la ou les couche(s) en matériau semi-conducteur formant la cavité optique.

Avantageusement, l'hétérojonction comprend des couches barrière, permettant une forte réduction du courant de diffusion.

Selon une variante, l'une au moins des couches barrière est structurée sur au moins une partie de son épaisseur pour former un réseau de couplage avec la cavité optique. Les déposants ont montré que cette configuration permettait de réduire encore le courant d'obscurité du fait de la réduction de la surface active.

Selon une variante, l'élément de photodétection selon le premier aspect est adapté pour une détection dans l'une des bandes I, II ou III de l'infrarouge.

Selon un deuxième aspect, l'invention concerne un détecteur infrarouge comprenant un assemblage d'éléments de photodétection quantique selon le premier aspect.

Selon un troisième aspect, l'invention concerne des méthodes de fabrication d'un élément de détection quantique selon le premier aspect.

Selon une variante, la méthode comprend :

- La formation sur un substrat d'une structure épitaxiée, comprenant un empilement de couches en matériau semi-conducteur, dont au moins une couche en matériau semi-conducteur absorbant de longueur d'onde de coupure $\lambda_c > \lambda_0$, et une couche supérieure en matériau diélectrique,
- La structuration de la couche supérieure en matériau diélectrique pour former un réseau de couplage,
- Le dépôt sur ledit réseau de couplage d'une couche réflective métallique,
- Le retrait du substrat pour former la face avant de l'élément de détection.

Avantageusement, la formation de la structure épitaxiée comprend une épitaxie par voie organométallique.

BREVE DESCRIPTION DES DESSINS

D'autres avantages et caractéristiques de l'invention apparaîtront à la lecture de la description, illustrée par les figures suivantes:

- Figures 1A et 1B (déjà décrites), diagramme d'énergie des électrons dans une jonction PN et caractéristiques courant/tension d'une photodiode en fonction de l'éclairement;

- Figure 2 (déjà décrite), exemple de détecteur selon l'art antérieur;

- Figures 3A et 3B, exemples de détecteurs selon la présente description ;

- Figures 4A à 4C, exemples de structures de couplage dans des éléments de détection selon la présente description ;

- Figures 5A à 5E, exemples de réseaux de couplage à une ou deux dimensions adaptés à un élément de détection selon la présente description ;

- Figure 6, schéma illustrant les principaux éléments du résonateur optique mis en œuvre dans un élément de détection selon un exemple de réalisation, dans lequel le résonateur optique forme un guide d'onde;

- Figure 7, schéma de principe illustrant les chemins de propagation des ondes dans un guide d'onde du type de celui décrit sur la figure 6 suivant les ordres diffractés 0 et $\pm 1$ (en incidence normale);

- Figure 8, courbes d'absorption en fonction de la longueur d'onde dans un élément de détection mettant en ouvre un résonateur du type de celui décrit sur la figure 6, dans le cas d'une hétérojonction de type InP/InGaAs;

- Figures 9A, 9B, images calculées représentant la répartition du champ électromagnétique à la longueur d'onde centrale de la bande spectrale de détection en polarisation TE et TM respectivement, dans les couches de la figure 6 et figures 9C, 9D, images calculées représentant la répartition du champ électromagnétique à la longueur d'onde radiative en polarisation TE et TM respectivement, dans les couches de la figure 6;

- Figure 10, schéma illustrant dans un exemple d'élément de détection selon la présente description, une hétérojonction de type InP/InGaAs ;

- Figure 11, courbes représentant le courant de diffusion dans une hétérojonction de type InP/InGaAs, comparé au courant de diffusion dans des jonctions de type InP et InGaAs respectivement ;

- Figure 12, courbes représentant la somme du courant de diffusion et du courant de génération-recombinaison radiative dans une hétérojonction de type InP/InGaAs, comparé au courant de diffusion dans des jonctions de type InP et InGaAs respectivement ;

- Figures 13A et 13B, un schéma montrant une cartographie du potentiel électrostatique dans un élément de photodétection du type de la figure 10, et une courbe montrant le taux de recombinaison radiative calculé en polarisation inverse en fonction de la position dans l'élément de photodétection selon une coupe transversale S de la figure 13A ;

- Figure 14, spectre d'électroluminescence déterminé expérimentalement dans une hétérojonction du type de celle représentée sur la figure 10 ;

- Figure 15, courbes montrant respectivement le spectre d'absorption de la cavité optique formée par la structure représentée sur la figure 10, le spectre d'électroluminescence de l'hétérojonction, la luminance de la cavité résultant du produit des spectres d'absorption et d'électroluminescence ;

- Figures 16A à 16G, schémas représentant différentes étapes d'un exemple de procédé selon la présente description.

DESCRIPTION DETAILLEE

Sur les figures, les éléments identiques sont référencés par les mêmes repères. Les figures sont données à titre illustratif et les échelles ne sont pas nécessairement respectées.

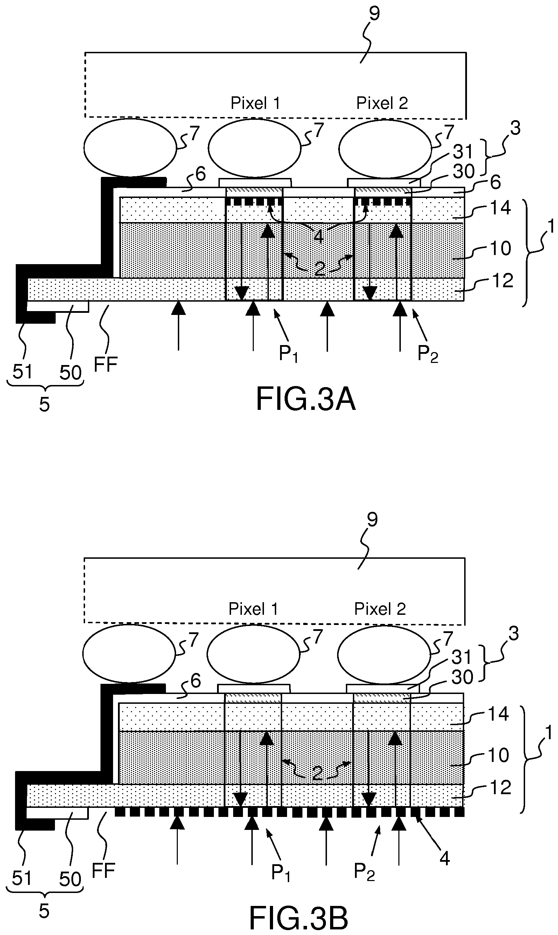

Les figures 3A et 3B représentent deux exemples de détecteurs quantiques comprenant des éléments de photodétection quantique selon la présente description.

Comme dans l'exemple illustré sur la figure 2, le détecteur comprend un ensemble d'éléments de photodétection ($P_1$, $P_2$, ...), agencés par exemple de façon matricielle dans un plan focal d'une optique d'imagerie (non représentée). Sur les figures 3A et 3B, la distance inter-pixel est surestimée pour des raison de lisibilité des figures ; Les éléments de photodétection sont adaptés à la détection d'un rayonnement incident dans une bande spectrale centrée autour d'une longueur d'onde centrale $\lambda_0$, par exemple dans une des bandes I, II ou III de l'infrarouge, correspondant aux bandes spectrales de transparence atmosphérique. Le détecteur comprend une face avant FF destinée à recevoir le rayonnement lumineux, indiqué par des flèches sur les figures 3A et 3B, ainsi qu'un circuit de lecture 9, agencé du côté opposé à la face avant. Chaque élément de photodétection comprend un premier contact électrique 3 relié au circuit de lecture par exemple par une bille d'indium 7 pour former autant de « pixels » du détecteur. Un deuxième contact électrique 5, commun à tous les pixels, permet de fermer le circuit électrique de chacun des éléments de photo détection.

Chaque élément de photodétection comprend dans ces exemples un empilement de couches en matériau semi-conducteur formant une jonction 1 de type PN ou PIN, avec notamment une couche 10 en matériau semi-conducteur absorbant de longueur d'onde de coupure $\lambda_c > \lambda_0$. Avantageusement, l'empilement des couches en matériau semi-conducteur forme une hétérojonction de type PIN, la couche 10 en matériau semi-conducteur absorbant formant la zone dite Intrinsèque I non dopée intentionnellement. L'hétérojonction, dont des exemples seront décrits plus en détails par la suite, comprend dans ces exemples d'autres couches en matériau semi-conducteur dont des couches barrière 12 et 14, agencées de part et d'autre de la couche 10.

La couche 6 peut avoir deux rôles complémentaires. D'une part, elle peut servir de couche de passivation lorsque la ZCE atteint la surface du détecteur. C'est le cas par exemple lorsque les zones dopées P+ sont réalisées par diffusion ou implantation ionique locale de dopants (par exemple du zinc) générant une ZCE à l'interface de ces zones et du matériau de type N. C'est également le cas lorsque les pixels sont isolés par gravure profonde d'un mesa. D'autre part, elle peut servir de protection ou encapsulation contre les agressions du milieu extérieur. C'est particulièrement utile au cours du procédé d'hybridation mais c'est aussi utile pour réduire les effets de vieillissement à long terme du détecteur. Dans la présente description, les pixels sont avantageusement électriquement isolés les uns des autres, soit en gravant tout ou partie de la couche barrière 14 entre les pixels, soit, comme cela sera décrit plus en détails par la suite, par diffusion d'hydrogène atomique dans la couche barrière entre les pixels, ce qui a pour effet de rendre ces zones fortement résistives électriquement. La ZCE n'étant pas en contact avec la surface du dispositif, le procédé de fabrication est ainsi facilité et les courants de périphérie liés de type SRH sont réduits par rapport aux procédés connus selon l'art antérieur. La couche 6 peut cependant être conservée pour son rôle de protection déterminant sur le vieillissement du détecteur.

Dans les exemples représentés sur les figures 3A et 3B, chaque élément de photodétection comprend par ailleurs une couche réflective métallique 30 agencée sur une face opposée à la face avant FF destinée à recevoir le rayonnement incident, ainsi qu'une structure de couplage 4, par exemple un réseau de couplage formé d'une couche en matériau diélectrique structuré. L'ensemble des couches en matériau diélectrique non structurées, situées entre la couche réflective 30 et la face d'entrée, sont avantageusement choisies pour présenter des indices de réfractions dont les parties réelles sont proches. Elles forment une cavité optique résonante 2, par exemple un guide d'onde, d'épaisseur *e* donnée. La structure de couplage 4 du rayonnement incident avec la cavité optique, formée dans le cas des exemples 3A et 3B par un réseau de couplage, est adaptée pour former une résonance à la longueur d'onde centrale $\lambda_0$ correspondant à une absorption quasi-totale (>80%) localisée dans la couche en matériau semi-conducteur absorbant 10 et une absorption réduite dans la couche en matériau semi-conducteur absorbant à une longueur d'onde $\lambda_{rad}$, appelée longueur d'onde radiative dans la présente description, et pour laquelle le taux de recombinaison radiative est maximal.

Le taux de recombinaison radiative *R* dans la couche en matériau semi-conducteur est donné par la relation suivante :

$$R \propto \sqrt{(E - E_g)}\, e^{-(E - E_g)/kT} \qquad (1)$$

où $E = hc/\lambda$ est l'énergie des photons émis à la longueur d'onde $\lambda$ (*h* constante de Planck et *c* vitesse de la lumière), $E_g$ est l'énergie de bande interdite (ou gap) du matériau semi-conducteur absorbant ($E_g = hc/\lambda_c$), k est la constante de Boltzmann et T la température. Ainsi, l'énergie des photons incidents $E_{rad}$ pour laquelle le taux de recombinaison radiative est maximal est l'énergie pour laquelle la dérivée de l'équation (1) s'annule, soit :

$$E_{rad} = \frac{kT}{2} + E_g \qquad (2)$$

Cela correspond à une longueur d'onde $\lambda = \lambda_{rad}$, appelée « longueur d'onde radiative » dans la suite de la description, telle que :

$$\frac{1}{\lambda_{rad}} = \frac{1}{\lambda_c} + \frac{kT}{2hc} \qquad (3)$$

En pratique, on choisit un matériau semi-conducteur absorbant de longueur d'onde de coupure $\lambda_c$ strictement supérieure à la longueur d'onde centrale de la bande spectrale de détection recherchée pour l'élément de photodétection. A température ambiante, la longueur d'onde radiative qui est strictement inférieure à la longueur d'onde de coupure tout en restant très proche, se trouve donc comprise au sens strict entre la longueur d'onde de résonance de la cavité optique et la longueur d'onde de coupure $\lambda_c$ du matériau semi-conducteur absorbant.

Les déposants ont ainsi montré, comme cela sera décrit par la suite, une diminution du courant de génération-recombinaison lorsque la réduction de l'absorption (donc de l'émission) à $\lambda_{rad}$ est supérieure à $\exp(\Delta E/kT)$ où $\Delta E$ est l'écart en énergie entre $\lambda_o$ et $\lambda_{rad}$.

En effet, une réduction de l'absorption-émission à $\lambda_{rad}$ supérieure à $\exp(E_o\text{-}E_{rad}/kT)$ se traduit par une réduction du courant d'obscurité supérieure à l'augmentation de ce courant résultant de la réduction de la largeur de bande interdite égale à Eo-Erad. Du fait de la mise en œuvre d'une cavité optique résonante, la couche en matériau semi-conducteur absorbant peut être réduite ; elle peut être par exemple comprise entre quelques dizaines et quelques centaines de nanomètres pour une couche en InGaAs, permettant de gagner un facteur important sur la réduction de l'épaisseur par rapport aux structures de l'art antérieur. Cette réduction d'épaisseur se traduit par une réduction de l'épaisseur de la ZCE qui conduit à une réduction dans le même rapport d'une part des courants de recombinaison radiative et d'autre part des courants de recombinaison non-radiative de type SRH. Il en résulte une réduction importante (approximativement un ordre de grandeur) des courant d'obscurité.

Par ailleurs, une couche antireflet n'est plus nécessaire sur la face avant FF ; au contraire, on s'en affranchit pour rendre maximale la réflexion à l'interface de la couche en matériau diélectrique 12 avec le milieu incident (par exemple de l'air), pour générer des résonances dans la cavité optique.

Avantageusement, lorsque la cavité optique est formée de plusieurs couches en matériau diélectrique, les parties réelles des indices de réfraction diffèrent de moins de 20% pour éviter les réflexions parasites aux interfaces.

Dans les exemples des figures 3A et 3B, la couche réflective 30 en matériau métallique contribue par ailleurs à former le contact électrique 3 qui représente pour chaque pixel l'anode du circuit électrique formé par l'hétérojonction. Le contact électrique 3 permet le contact avec la bille d'indium. Il comprend par ailleurs, de façon optionnelle, une couche 31 pour l'hybridation avec la bille d'indium. Comme dans l'exemple de la figure 2, la cathode du circuit est formée par un contact déporté 5, le contact électrique 5 comprenant par exemple une couche en matériau conducteur 50 en contact électrique avec la couche barrière 12 et une couche en matériau conducteur 51 permettant le contact avec le circuit de lecture 9.

Comme cela est illustré sur la figure 3A, la structure de couplage peut comprendre un réseau en face arrière. La structuration peut être réalisée dans la couche métallique pour former le réseau de couplage ou dans une couche en matériau semi-conducteur, par exemple la couche barrière 14. Comme cela est illustré sur la figure 3B, la structure de couplage peut comprendre un réseau de couplage en face avant. La structure de couplage peut être obtenue par dépôt d'un réseau sur la couche en matériau semi-conducteur 12, comme cela est illustré sur la figure 3B, ou directement par structuration de la couche en matériau semi-conducteur 12. La structure de couplage peut également comprendre un réseau en face avant et un réseau en face arrière. D'autres réseaux de couplage sont possibles, par exemple des réseaux métal - diélectrique.

Par ailleurs, le(s) réseau(x) de couplage peut (peuvent) être limité(s) aux dimensions d'un pixel (figure 3A) ou être étendu(s) sur un ensemble de pixels (figure 3B).

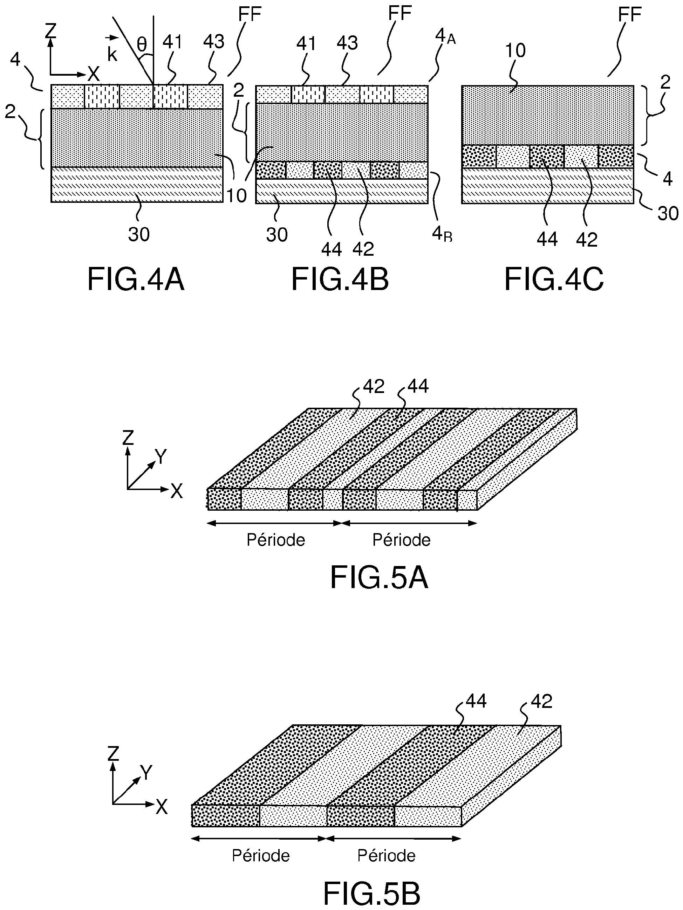

Les figures 4A à 4C illustrent ainsi différentes variantes de structures de couplage adaptées à la réalisation d'un élément de photodétection selon la présente description.

Sur ces figures, par souci de simplification, la ou les couches en matériau diélectrique formant la cavité optique 2 sont réduites à la seule couche 10. Seule est représentée par ailleurs la couche réflective 30, qui est dans tous les cas agencée en face arrière.

L'exemple de la figure 4A montre une structure de couplage avec un seul réseau de couplage en face avant. Le réseau 4 est transparent ou semi-transparent pour laisser passer au moins une partie du rayonnement, symbolisé sur la figure 4A par le vecteur d'onde k. Il s'agit par exemple d'un réseau formé d'alternances de deux matériaux diélectriques 41 et 43, semi-conducteur, ou isolant, ou air, d'indices différents. Alternativement, il peut s'agir d'une alternance d'un matériau métallique et d'un matériau diélectrique, semi-conducteur, isolant ou air.

La figure 4C montre une structure de couplage avec un seul réseau de couplage en face arrière. Le réseau 4 est constitué par exemple d'un réseau formé d'alternances de deux matériaux diélectriques 42, 44, dont l'un au moins est conducteur ; il peut s'agir également d'une alternance entre un matériau métallique ou semi-conducteur, et un matériau diélectrique, de type semi-conducteur, ou isolant, ou air.

La figure 4B représente un exemple de structure de couplage comprenant deux réseaux $4_A$ et $4_B$ respectivement en face avant et arrière. Comme dans l'exemple de la figure 4A, le réseau en face avant est transparent ou partiellement transparent. Le réseau en face arrière comprend au moins un matériau conducteur. La pluralité de réseaux (2 ou plus) permet notamment de faciliter la génération d'antirésonances.

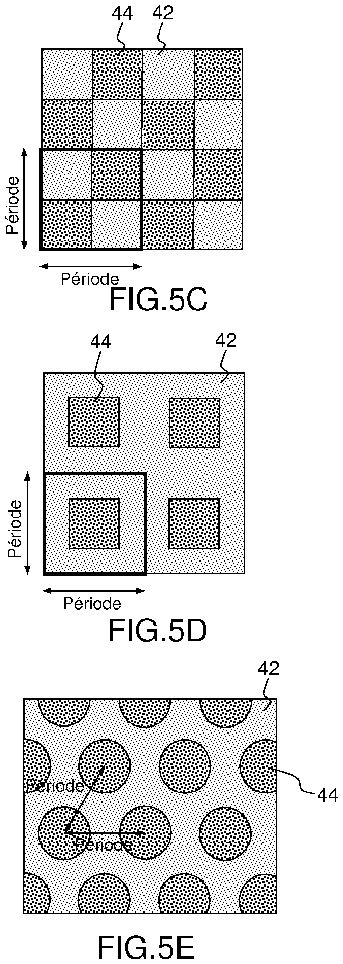

Les figures 5A à 5E illustrent dans le cas de réseaux de couplage, plusieurs formes possibles de réseaux, à une ou deux dimensions.

Alternativement aux réseaux de couplage illustrés au moyen des figures 3 à 5, les structure de couplage peuvent comprendre des structures de type métal-diélectrique-métal (MDM), telles que décrites par exemple dans la demande de brevet FR 2959352. A noter que dans ce dernier cas, une structuration périodique n'est pas nécessaire mais plutôt motivée pour des raisons technologiques. En effet, les structures de type MDM agissent individuellement comme des nano-antennes.

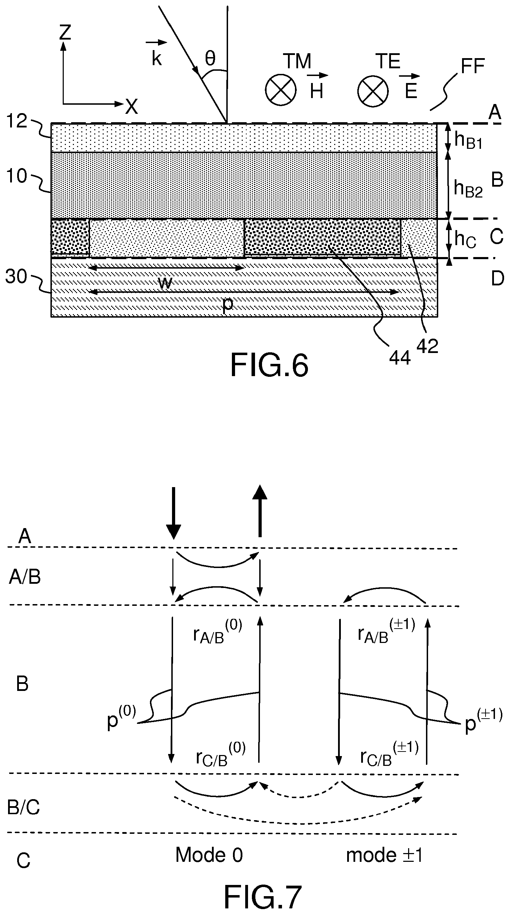

La figure 6 illustre selon une variante, le schéma optique d'un élément de détection selon la présente description mettant en œuvre une cavité optique de type guide d'onde avec un réseau de couplage en face arrière. Le schéma optique de l'élément de détection ainsi illustré comprend une région A correspondant au milieu dans lequel le rayonnement lumineux est incident (par exemple de l'air), une région B correspondant au guide d'onde, une région C correspondant au réseau de couplage et une région D correspondant au miroir métallique.

De façon structurelle, l'élément de détection comprend une ou plusieurs couches en matériau semi-conducteur non structurée(s) 10, 12, d'épaisseurs $h_{B1}$, $h_{B2}$, formant le guide d'onde. L'ensemble des couches, d'indices de réfraction proches, est assimilée du point de vue optique à une couche unique B d'indice moyen donné. L'élément de détection comprend en outre un réseau périodique (région C), à une ou deux dimensions, d'épaisseur $h_C$, constitué par exemple d'une part du/des même(s) matériau(x) semi-conducteur(s) 44 que le guide d'onde, et d'autre part d'un matériau diélectrique électriquement isolant 42. Le réseau est caractérisé par une période p et un facteur de remplissage w/p. Enfin l'élément de détection comprend une couche réflective 30 (région D), avantageusement une couche en matériau métallique servant à la fois de contact ohmique et de miroir optique (par exemple, de l'or). Les résonances mises en œuvre sont des résonances de modes guidés. Elles ont lieu dans le guide d'onde, et sont obtenues grâce au couplage entre l'onde incidente et les modes du guide. Le couplage est assuré par le réseau périodique.

Une couche fine de semi-conducteur entourée de matériaux d'indice optique plus faible se comporte en effet comme un guide d'onde : l'onde peut se propager selon des modes guidés, caractérisés par une variation de phase égale à 0 (modulo $2\pi$) après un aller-retour dans la couche (c'est à dire entre les interfaces A/B et B/C). Il y a résonance lorsque l'onde incidente est couplée à l'un de ces modes. L'énergie incidente est alors stockée dans ce mode (les photons effectuent plusieurs aller-retour) ce qui augmente les composantes du champ électromagnétique dans le guide et par suite la probabilité d'absorption (proportionnelle au carré du champ électrique) des photons ainsi piégés. Pour coupler l'onde incidente aux modes du guide d'onde, on introduit des structures de couplage, périodiques ou non, d'un côté et/ou de l'autre du guide. Dans l'exemple de la figure 6, le couplage est réalisé en structurant périodiquement la face arrière du guide d'onde de façon à ce qu'au moins un ordre diffracté par le réseau coïncide avec au moins un mode du guide.

Selon une variante, la période est choisie de telle sorte que seuls trois ordres (0, +1 et -1) soient diffractés par le réseau dans le guide d'onde.

La figure 7 illustre les échanges entre l'onde incidente et les deux modes de diffraction (mode associé à l'ordre 0, et mode associé à la combinaison symétrique des ordres +1 et -1) en incidence normale dans le guide d'onde dans le cas où les trois ordres (0, +1 et -1) sont diffractés par le réseau dans le guide d'onde. Dans ce cas, la variation de phase associée à un aller-retour d'un mode de diffraction dans la couche est égale à 0 (modulo 2 $\pi$), soit :

$$\varphi(r_{A/B}{}^{(m)} \exp(2ik_z{}^{(m)}h)\, r_{C/B}{}^{(m)}) = 0\ [2\pi],$$

où m est le mode de diffraction qui nous intéresse, et les termes $r_{A/B}{}^{(m)}$ et $r_{C/B}{}^{(m)}$ sont les coefficients de réflexion aux interfaces A/B et B/C du mode de diffraction. Sur la figure 7, la résonance est associée à un couplage du mode 0 avec les modes (+1, -1) du guide d'onde. La superposition des résonances en TE et TM est avantageusement obtenue en ajustant la phase associée au coefficient de réflexion $r_{C/B}{}^{(m)}$ pour les deux polarisations avec les paramètres du réseau (période p, facteur de remplissage w/p, et épaisseur $h_C$).

Il est ainsi possible en jouant sur les paramètres optiques de la structure d'obtenir un maximum d'absorption (résonance) à la longueur d'onde centrale de la bande spectrale d'intérêt et au contraire une faible absorption, avantageusement un minimum d'absorption (antirésonance) à la longueur d'onde radiative.

Avantageusement, on recherche dans le résonateur optique de l'élément de photodétection selon la présente description, à obtenir une résonance de type Fabry-Pérot dans le guide d'onde à la longueur d'onde centrale de la bande spectrale de détection et à confiner latéralement le champ électrique à la résonance dans le guide d'onde grâce aux ordres +1 et -1 diffractés par le réseau.

Par définition, la résonance de Fabry-Pérot apparaît lorsque la phase accumulée par le mode fondamental dans le guide d'onde après un aller-retour entre les deux interfaces (A/B et B/C sur la figure 7) est égale à 0 (modulo 2pi). Elle se caractérise par l'apparition d'ondes stationnaires dans le guide d'onde, avec des successions de ventres (maxima de champ) et nœuds (minimum de champ) suivant la direction verticale. L'objectif est d'avoir au moins un ventre de résonance dans la couche absorbante afin d'y avoir une absorption importante, ce qui correspond à une résonance de Fabry-Pérot à l'ordre 1. A l'ordre 0 en effet, il n'y a qu'un ventre de résonance, situé à l'interface air/guide d'onde ; à l'ordre 1, il y a toujours ce ventre de résonance, avec un ventre de résonance en plus à $\lambda$ /2n de l'interface. C'est ce deuxième ventre que l'on souhaite avoir au niveau de la couche active.

Pour atteindre cette configuration de résonateur, il est possible de choisir une épaisseur de guide d'onde de l'ordre de 3 $\lambda_0$/4n, où n est l'indice du milieu composant le guide d'onde. Pour le réseau, comme on a besoin des ordres 0, +1 et -1, on peut alors fixer la période à mi-chemin entre $\lambda_0/n$ et $\lambda_0$. De cette manière, les ordres 0, +1 et -1 se propagent dans le guide d'onde (car $p > \lambda_0/n$), et les ordres +1 et -1 sont en réflexion totale interne à l'interface avec l'air (car $p < \lambda_0$), et pourront avoir une contribution importante sur la répartition du champ électrique. Pour les autres paramètres du réseau, on peut prendre un facteur de remplissage de 50 % et une épaisseur de l'ordre de $\lambda_0/4n$. Dans ces conditions, la résonance de Fabry-Pérot recherchée en polarisation TE ou TM se trouve à une longueur d'onde proche de $\lambda_0$. Pour l'identifier, on peut soit vérifier que la résonance est indépendante de l'angle d'incidence, soit vérifier que la phase associée à un aller-retour du mode 0 dans le guide d'onde est bien égale à 0 (modulo 2pi) à la résonance. Pour cela, il faut étudier la phase associée au produit ($p^{(0)}r_{B/C}{}^{(0)}p^{(0)}r_{A/B}{}^{(0)}$), qui correspond au gain de l'ordre 0 après un aller-retour dans la couche, selon les notations de la figure 7. Une fois la résonance identifiée pour chaque polarisation (TE et TM), il s'agit d'ajuster les épaisseurs du guide d'onde et du réseau, ainsi que la période et le facteur de remplissage du réseau, afin de superposer les résonances en polarisation TE et TM à $\lambda_0$.

Au terme de cette étape, on a donc un pic de résonance à $\lambda_0$ pour chaque polarisation, résultant du même mécanisme de résonance. Le champ électrique dans la structure est alors caractérisé par un premier ventre de résonance à l'interface air/guide d'onde, et un deuxième ventre de résonance à $\lambda_0/2n$ sous le premier ventre de résonance. Les deux ventres sont confinés latéralement dans une demi-période du réseau, et sont situés au-dessus de la partie conductrice du réseau (métal ou semiconducteur). Pour une résonance de Fabry-Pérot classique où l'onde ne se propage dans la cavité que dans le mode 0, le champ électrique est invariant selon la direction horizontale (x). Le confinement que l'on obtient s'explique par la présence d'un champ électrique associé à la combinaison symétrique des ordres +1 et -1 en plus du champ électrique associé au mode 0. La somme de ces deux termes de champ (constant selon x pour le mode 0, variant comme $\cos(2\pi x/p)$ pour le mode +-1, où p est la période du réseau), donne lieu à un maximum de champ à x=x0 et un minimum de champ à x=x0+p/2, où x0 est le milieu de la partie semi-conductrice du réseau.

Le confinement latéral du champ électrique au-dessus des parties conductrices du réseau permet de réduire encore le courant d'obscurité. En effet, les déposants ont montré que la structuration de la face arrière de l'hétérojonction permet de rendre électriquement inactive les zones situées au niveau des parties gravées. Il en résulte que ces zones ne génèrent pas de courant d'obscurité, soit pour un facteur de remplissage de 50 %, une réduction du courant d'obscurité total de 50 %. Cependant, les photons absorbés dans cette région ne génèrent pas de photocourant. Pour conserver un rendement quantique élevé, il est avantageux que tous les photons soient absorbés dans les parties électriquement actives de l'hétérojonction. C'est le cas de la résonance présentée ici.

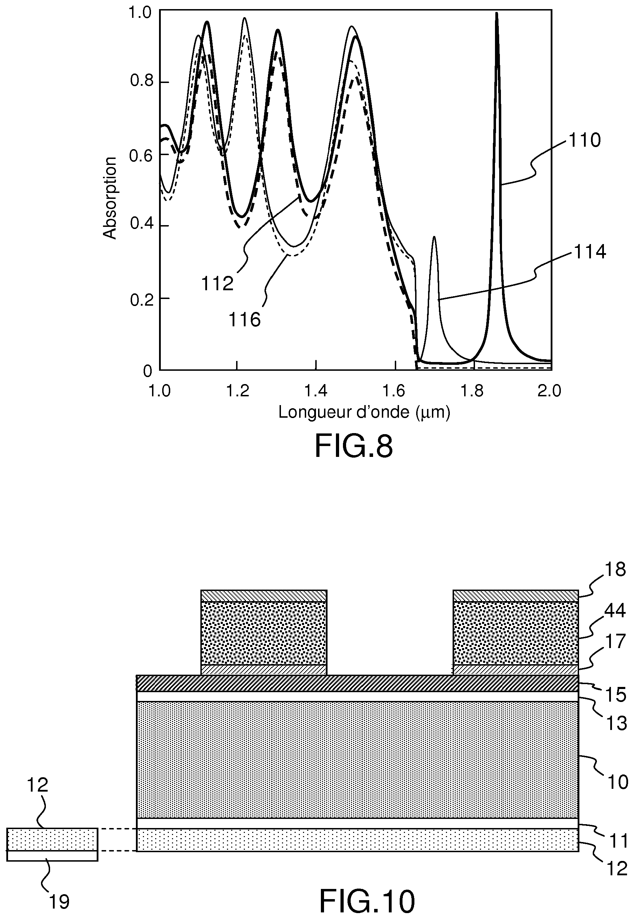

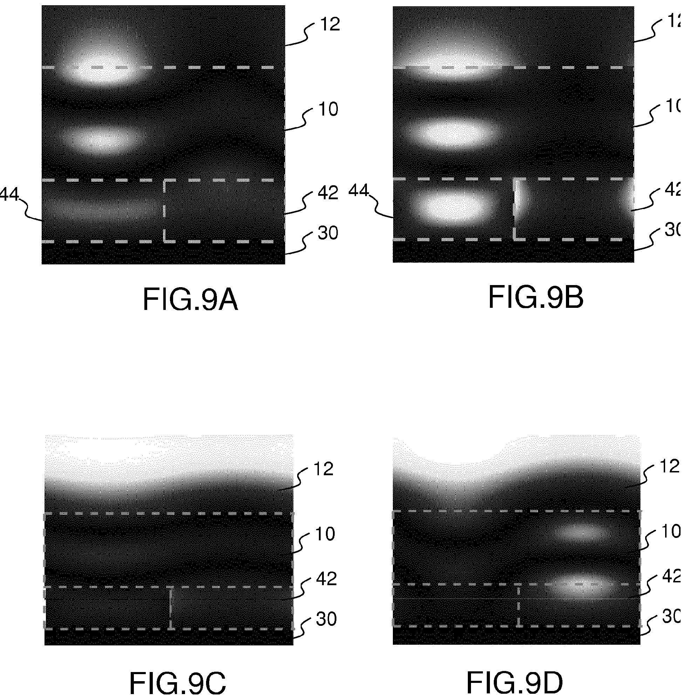

Les figures 8, 9A et 9B représentent respectivement le spectre d'absorption et les cartes du champ électrique $|E|^2$ à la longueur d'onde de résonance en polarisation TE (figure 9A) et TM (figure 9B), dans les différentes régions A, B, C, D d'un élément de photodétection dont le schéma optique simplifié est représenté sur les figures 6 et 7. Les paramètres sont optimisés pour un fonctionnement de l'élément de photodétection dans la bande I de l'infrarouge, autour de 1,5 $\mu$m, l'ensemble des couches en matériau semi-conducteur formant une hétérojonction de type InGaAs/InP. Plus précisément, les simulations numériques sont obtenues avec un code de simulation électromagnétique, basé par exemple sur la méthode modale B-Spline (BMM), ou la méthode modale de Fourier (FMM). Les simulations ont été effectuées en prenant comme valeur d'indices n(InP) = 3.2, n(diélectrique) = 2, n(air) = 1. Les indices de l'InGaAs et de l'or sont calculés respectivement à l'aide des formules théoriques données dans les articles (Sadao Adachi. Optical dispersion relations for GaP, GaAs, GaSb, InP, InAs, InSb, Al$x$Ga1-$x$As, and In1-$x$Ga$x$As$y$P1-$y$. Journal of Applied Physics, 66(12) :6030-6040, 1989) et Aleksandar D. Rakic, Aleksandra B. Djurisic, Jovan M. Elazar, and Marian L. Majewski. Optical properties of metallic films for vertical-cavity optoelectronic devices. Applied Optics, 37(22) :5271-5283, 1998.). Les autres paramètres optiques de la structure sont donnés dans le tableau 1 ci-dessous.

**Tableau 1 : Dimensions des couches de la structure optique**

| Paramètres | Valeurs (nm) |
|---|---|
| $h_{B1}$ | 61 |
| $h_{B2}$ | 315 |
| $h_C$ | 200 |
| w | 400 |
| p | 800 |

Les simulations numériques sont réalisées avec le code BMM, basé sur la méthode modale B-Spline (voir P.Bouchon et al., « Fast modal method for subwavelength gratings based on B-spline formulation », Journal of the Optical Society of America A, 27(4) :696-702, 2010).

Les simulations numériques ont permis de montrer que ce type de structure présente pour les polarisations TE et TM, une absorption quasi-parfaite à $\lambda$=1.5 $\mu$m et une absorption réduite à $\lambda_{rad}$=1.62 $\mu$m

La figure 8 représente les spectres 110, 114 d'absorption totale calculés respectivement en mode TM et TE pour un dispositif ayant les dimensions telles que décrits dans le tableau 1 et en incidence normale. On observe une absorption quasi parfaite, autrement dit une résonnance, en TE et en TM à $\lambda$=1.5$\mu$m. Sur cette même figure sont représentés les spectres 112, 116 d'absorption calculés uniquement dans la couche 10 en matériau semi-conducteur. Les spectres d'absorption dans la cavité optique prise dans son ensemble et les spectres d'absorption uniquement dans la couche 10 ont un comportement similaire pour des longueurs d'onde en dessous de 1.6$\mu$m. La couche 10 en semi-conducteur absorbe et génère donc le photocourant. Les quelques différences sont dues aux pertes par absorption dans les parties métalliques. On observe ainsi 80% d'absorption utile dans 315 nm d'InGaAs à $\lambda_0$=1.5 $\mu$m, correspondant à un gain de 2.5 sur la détectivité par rapport à une absorption non résonante. Dans l'état de l'art, le rayonnement est absorbé sur un trajet simple, avec 80 % d'absorption pour une couche semi-conductrice de 2 $\mu$m d'épaisseur. Dans le dispositif décrit dans la présente demande, l'absorption est la même que celle obtenue dans l'état de l'art mais le courant d'obscurité est 6 fois plus faible ; il y a un gain d'un facteur 2.5 sur la détectivité.

Comme décrit précédemment, les résonances de modes guidés sont associées à l'apparition d'ondes stationnaires, résultant de la combinaison d'ondes contra-propagatrices (horizontale et verticale) dans le guide d'onde. Ces interférences sont caractérisées par des extrema locaux du champ électrique. Les figures 9A et 9B illustrent pour les polarisations TE et TM, les cartes du champ électrique $|E|^2$ pour la résonance observée à 1,5 $\mu$m de la figure 8. L'absorption, proportionnelle à $|E|^2$, n'est effective que si le semi-conducteur présente une largeur de bande interdite ($E_g$) suffisamment faible ($\lambda < \lambda_c$ où $\lambda_c$=1.24/$E_g$). On observe sur les figures 9A et 9B que les deux ventres de résonance (en blanc sur les figures) sont confinés latéralement dans une demi-période du réseau, et sont situés au-dessus de la partie conductrice du réseau (métal ou semiconducteur) dans la couche en matériau semi-conducteur absorbant. Les figures 9C et 9D illustrent pour les polarisations TE et TM, les cartes du champ électrique $|E|^2$ pour la longueur d'onde radiative $\lambda_{rad}$ = 1,62 $\mu$m. On observe a contrario une absence du champ électrique dans la couche en matériau semi-conducteur absorbant à la longueur d'onde radiative, résultant de la non résonance à cette longueur d'onde.

La figure 10 représente un schéma illustrant un exemple particulier d'une hétérojonction, par exemple une hétérojonction de type InP/InGaAs adapté pour la détection en bande I de l'infrarouge, structurée de telle sorte à ce qu'une des couches barrière de l'hétérojonction ait la fonction de réseau de couplage dans le schéma optique simplifié représenté par exemple sur la figure 6.

Dans cet exemple, plus précisément, l'hétérojonction comprend une zone de type P (ensemble des couches 44, 17, 15, 13), une zone intrinsèque I (10) et d'une zone de type N (ensemble des couches 11 et 12) pour former une jonction PIN. La zone intrinsèque est une couche absorbante réalisé avec un semi-conducteur dont la largeur de bande interdite est plus faible que l'énergie des photons incidents. Préférentiellement la longueur d'onde incidente $\lambda_0$ est plus faible que la longueur d'onde radiative $\lambda_{rad}$ (voir équation (3) supra) afin d'avoir une meilleure absorption mais aussi de pouvoir différencier spectralement absorption et émission radiative. La zone intrinsèque 10 est la zone active de l'élément de détection. Par exemple, la zone intrinsèque 10 peut être formée d'une couche d'InGaAs ayant une énergie de bande interdite de 0.74eV pour une détection à 0,8eV. Les zones de type P et de type N dites zones de quasi-neutralité (ZQN), sont composées de couches semi-conductrices fortement dopées respectivement P et N. Ces zones peuvent être notamment formées de plusieurs couches dont une plus importante en épaisseur, formant la couche corps, respectivement 15 et 44 pour la zone de type N et 12 pour la zone de type P. la couche corps de la ZQN a, préférentiellement, une largeur de bande interdite plus importante que celle de la zone intrinsèque 10, par exemple une largeur de bande interdite supérieure à 10$k_B$T avec $k_B$ la constante de Boltzmann et T la température du dispositif, avantageusement de l'InP. Les autres couches des zones dopées d'épaisseurs plus faibles 11, 13 et 17 que les couches corps des ZQN de type N et de type P sont formées du même matériau que celui de la couche de la zone intrinsèque, par exemple des couches d'InGaAs. Les fines couches d'InGaAs permettent, notamment, d'obtenir des bonnes conditions du transport électronique avec des faibles résistances de contact et une meilleure collection des porteurs majoritaires. Les couches corps dopées avec une largeur de bande interdite nettement plus important que celle de la zone intrinsèque permettent de réduire le courant de diffusion lié aux porteurs minoritaires. Par exemple, dans la zone de type N, la couche d'InP va avoir pour effet d'introduire des barrières de potentiel à l'interface InGaAs/InP à la fois dans la bande de valence et dans la bande de conduction. La barrière de potentiel de la bande de valence est suffisamment importante pour réduire la densité d'électrons injectés dans la ZQN. Le gradient des porteurs minoritaires dans cette zone étant réduit dans le même rapport, il en résulte une réduction dans le même rapport du courant de diffusion. La barrière de la bande de conduction est suffisamment fine pour que les électrons puissent passer par effet tunnel, assurant un équilibre thermodynamique des populations d'électrons de part et d'autre de cette barrière. Les porteurs majoritaires sont donc efficacement collectés alors que la diffusion des porteurs minoritaires est fortement réduite (d'un facteur proche de : exp($\Delta E_g/k_B$T)), le courant d'obscurité est donc réduit sans gêner la collecte du photo courant. Deux couches de contact électrique 18 et 19 sont présentes dans la structure. Ces contacts électriques sont réalisés avec un semi-conducteur à faible largeur de bande interdite, par exemple en InGaAs, pour assurer une faible résistance de contact. Sur la face d'entrée de la lumière, le contact 19 est déporté en bordure du détecteur ou de la matrice de détecteurs de façon à ne pas créer d'ombrage pour le flux incident de photons et également pour faciliter la fabrication. Sur la face supérieure le contact est structuré comme l'est la barrière de ce côté. Les couches supérieures dopés P sont structurées par une gravure sur la quasi-totalité de leurs épaisseurs. Une couche 17 placée dans la barrière supérieure a le rôle de couche d'arrêt pour la gravure. Elle permet le contrôle du procédé de fabrication. Elle n'a pas d'effet sur le courant d'obscurité. Le tableau 2 présente un exemple de composition d'une hétéro structure semi-conductrice pour un élément de détection quantique à faible bruit tel que décrit dans la présente demande.

**Tableau 2: Exemple de composition d'une hétéro structure semi-conductrice pour un élément de détection quantique à faible bruit**

| Zone | Référence | Matériau | Dopage (cm-3) | Epaisseur (nm) |
|---|---|---|---|---|
| P | 18 | InGaAs :C | $1^e19$ | 20 |
| P | 44 | InP :Be | $3^e18$ | 170 |
| P | 17 | InGaAs :C | $1^e19$ | 10 |
| P | 15 | InP :Be | $3^e18$ | 93 |
| P | 13 | InGaAs :C | $1^e19$ | 10 |
| I | 10 | InGaAs | - | 70 |
| N | 11 | InGaAs :Si | $5^e18$ | 10 |
| N | 12 | InP :Si | $3^e18$ | 204 |
| N | 19 | InGaAs :Si | $5^e18$ | 10 |

Une autre source de courant d'obscurité existe : le courant de surface principalement du aux processus de recombinaison non-radiatifs situés en bordure du dispositif. Ils sont très fortement réduits dans cette structure en supprimant tout contact de la zone de charge d'espace (principalement en InGaAs) avec la surface libre du dispositif. En effet la structuration de la partie haute du dispositif laisse une couche de semi-conducteur à grand gap faiblement dopée (ici InP hydrogéné) présentant une vitesse de recombinaison de surface faible ($\sim$ 5000cm/s).

De plus les pixels sont séparés les uns des autres par le même procédé : gravure de la zone de type P jusqu'à la couche d'arrêt en InGaAs. Dans une variante on pourra ne pas graver la zone de type P et pratiquer une diffusion d'hydrogène atomique à partir de la surface.

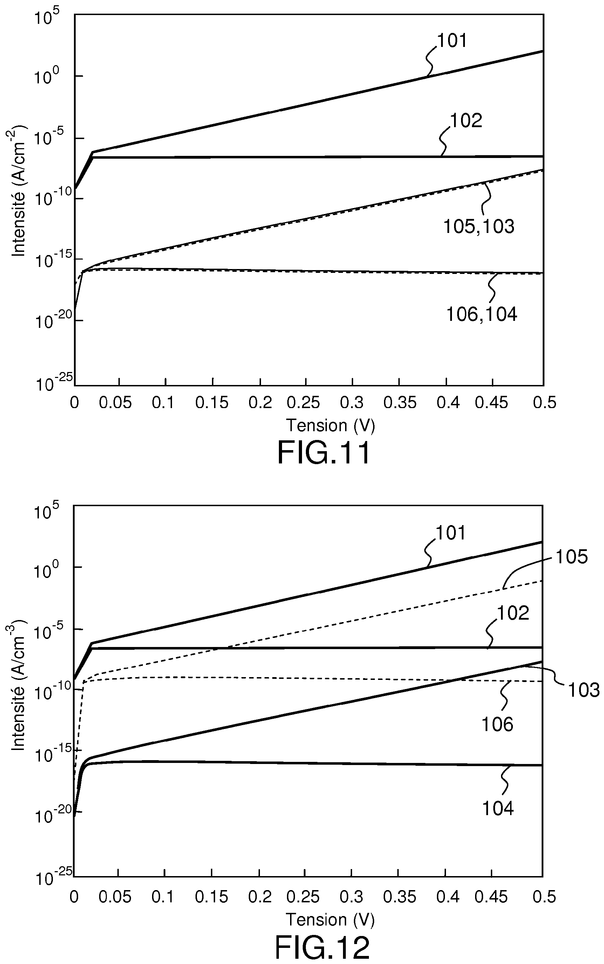

Pour valider cette approche, la figure 11 représente la caractéristique électrique courant-tension |I|(|V|) calculée pour la structure telle que représentée sur la figure 10, comparée à celle d'une jonction InGaAs et d'une jonction InP équivalentes (niveaux de dopage et épaisseurs conservés). Dans tous les cas, les recombinaisons radiatives ont été artificiellement supprimées. Les courbes 101, 102 représentent ainsi les caractéristiques courant-tension de la jonction InGaAs, respectivement en polarisation directe et inverse. Les courbes 103, 104 représentent les caractéristiques courant-tension de la jonction InP, respectivement en polarisation directe et inverse. Les courbes 105, 106 représentent les caractéristiques courant-tension de l'hétérojonction InGaAs/InP, respectivement en polarisation directe et inverse. L'insertion des barrières InP prenant « en sandwich » la jonction PIN en InGaAs permet effectivement de réduire le courant de diffusion de près de 10 ordres de grandeur (ici $\Delta Eg$ =23 $k_B T$). Ainsi la structure proposée (figure 10) présente un courant de diffusion comparable à celui d'une jonction InP tout en présentant l'absorption d'une jonction InGaAs.

La figure 12 représente les caractéristiques électriques courant-tension calculées pour les mêmes structures mais cette fois en tenant compte des phénomènes de recombinaison radiative. On observe que les caractéristiques courant-tension des jonctions InP (courbes 103, 104) et InGaAs (courbes 101, 102) sont similaires à celles calculées sans prendre en compte les recombinaisons radiatives. Dans ces structures, le courant de diffusion est dominant. Par contre, la très forte réduction du courant de diffusion dans l'hétérojonction InGaAs/InP rend dominante la contribution des phénomènes de recombinaison radiative (courbes 105, 106). Le courant d'obscurité de l'hétérojonction InP/InGaAs peut être ainsi réduit d'environ 3 ordres de grandeurs par rapport à celui d'une jonction InGaAs.

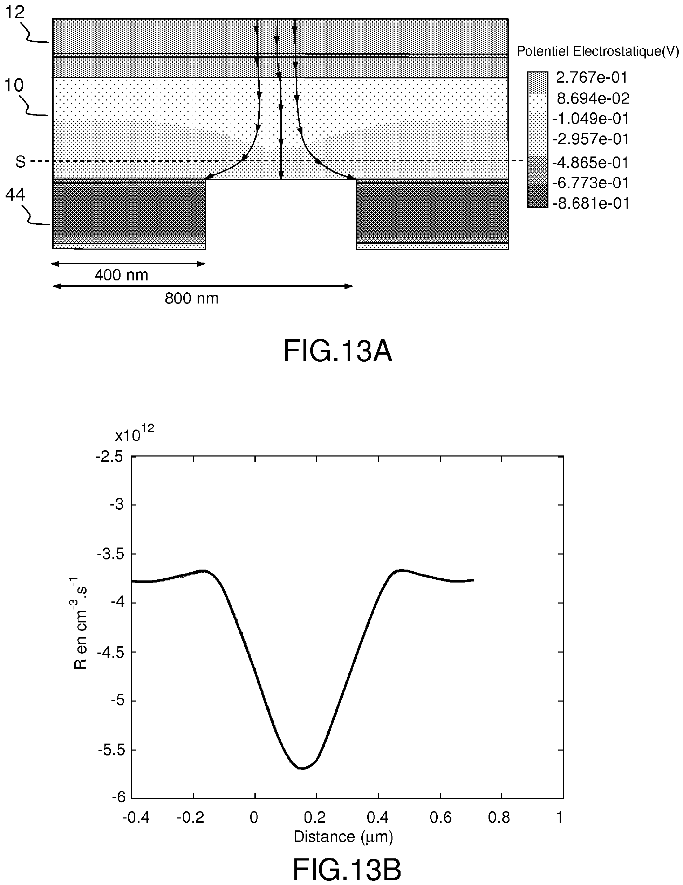

Les figures 13A et 13B illustrent l'effet de la structuration sur les phénomènes de génération-recombinaison radiatives. La figure 13A présente une cartographie du potentiel électrostatique en polarisation inverse (fonctionnement détecteur) dans un dispositif similaire à celui décrit sur la figure 10, avec les paramètres décrits dans le tableau 2. Les zones de type N (couche 12) ont un potentiel négatif relativement constant et les zones de type P (couche 44) ont un potentiel positif relativement constant. Dans la zone de charge d'espace (couche 10), le potentiel varie. Les lignes fléchées représentent les lignes de champ électrique. Sous l'effet du fort champ qui existe au niveau de la partie structurée de la couche 44, les paires électrons trous générées via la densité intrinsèque sont récoltées par les plots de semi-conducteurs. La figure 13B représente la modélisation du taux de recombinaison radiative R en polarisation inverse en fonction de la position dans le dispositif selon la coupe transversale S de la figure 13A. En polarisation inverse, dans la situation où il y a génération d'électrons et de trous, le taux de recombinaison est négatif. On observe une diminution du taux de recombinaison radiative centrée autour de $0{,}2\,\mu m$ qui correspond à la région entre les plots semi-conducteurs. On observe ainsi l'effet de la structuration sur le taux de recombinaison. En ajustant la structuration du réseau, il est possible de modifier le profil du taux de recombinaison par rapport à un profil plat d'un dispositif non structuré.

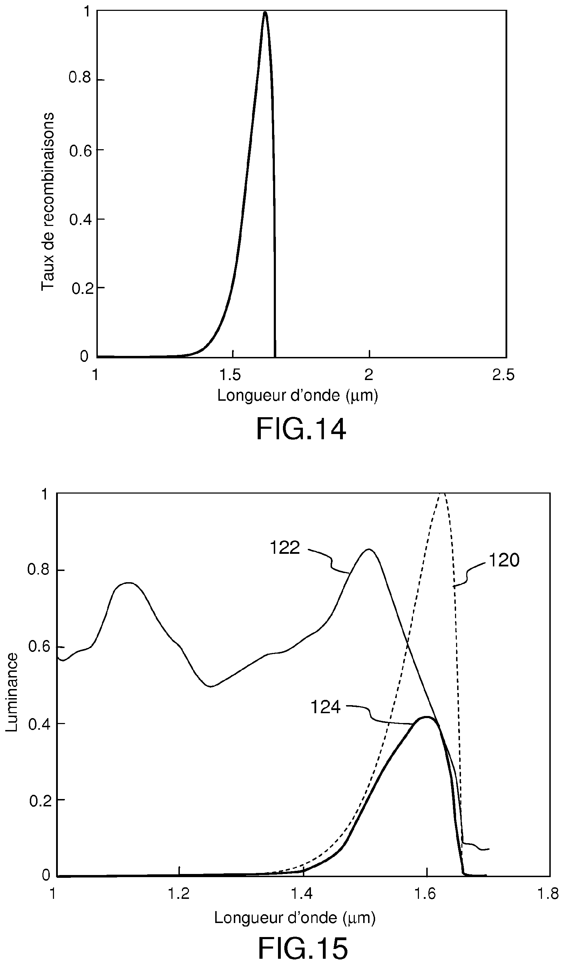

La figure 14 illustre le spectre d'électroluminescence calculé pour une photodiode à hétérojonction InGaAs/InP telle que représentée sur la figure 10, avec les paramètres donnés dans le tableau 2 et une polarisation directe de 0,57 V. Ce spectre a été mesuré sous forte tension directe pour faciliter l'expérience. On a pu montrer expérimentalement qu'il dépend très peu de la tension appliquée, en particulier son maximum reste fixé à la longueur d'onde $\lambda_{rad}$. La figure 14 montre ainsi les processus radiatifs à l'origine du courant d'obscurité en fonction de la longueur d'onde (également noté « luminance de l'hétérostructure »). La fonction tracée sur cette figure s'exprime comme : $R \propto \sqrt{(E - E_g)}e^{-(E-Eg)/kT}$, Eg=0.75 eV, où $E=hc/\lambda$, R le taux de recombinaison radiatif.

La mise en œuvre d'un résonateur optique tel que décrit précédemment permet de diminuer de façon très significative le courant de génération-recombinaison, lié aux effets de recombinaisons radiatives tels qu'ils ont été mis en évidence dans les figures 11 à 14.

Il est possible d'une part, grâce au résonateur optique selon la présente description, de réduire l'épaisseur de la zone I (couche active en matériau semi-conducteur absorbant). La composante correspondante de la densité de courant d'obscurité est alors réduite dans le rapport de réduction des épaisseurs. Ce faisant l'efficacité quantique du détecteur est également réduite. L'épaisseur de la zone I est avantageusement réduite à une valeur de compromis entre ces deux effets antagonistes. Il existe d'autre part une valeur limite, environ 50nm pour l'InGaAs, en dessous de laquelle la contribution de la composante de courant par effet tunnel bande à bande génère une augmentation du courant d'obscurité. En réduisant l'épaisseur de la couche d'InGaAs à 50 nm au lieu des 300nm de la structure précédemment décrite, tout en gardant une épaisseur des couches épitaxiées constante par augmentation de l'épaisseur des couches barrière en InP, on obtient une réduction d'un facteur 6 sur la densité de courant d'obscurité.

Par ailleurs, le dimensionnement du résonateur optique (paramètres de la cavité et de la structure de couplage) est adapté pour obtenir, à la longueur d'onde $\lambda_{rad}$ pour laquelle le taux de recombinaison radiative est maximal (voir équation 2 supra), un couplage réduit avec l'espace libre de façon à augmenter la durée de vie des porteurs dans cette zone. Il s'agit donc avantageusement de placer le dispositif de détection au sein d'un résonateur optique présentant une résonance à la longueur d'onde de détection $\lambda_0$ (couplage maximal avec l'espace libre) et une antirésonance (couplage minimal avec l'espace libre) à la longueur d'émission $\lambda_{rad}$. La réduction de l'absorption à $\lambda_{rad}$ ainsi produite est notamment, pour être utile, supérieure à $exp(\Delta E/kT)$ où $\Delta E$ est l'écart en énergie entre $\lambda_{rad}$ et $\lambda_o$.

La figure 15 représente en fonction de la longueur d'onde, l'absorption de la cavité moyennée sur tous les angles d'incidence (courbe 122), la luminance de l'hétérojonction (courbe 120) et la luminance résultant de la cavité, obtenue par multiplication des deux spectres. On observe bien l'effet recherché par le résonateur optique mis en œuvre dans la présente description, à savoir un maximum d'absorption à la longueur d'onde centrale de la bande spectrale d'intérêt (ici $\lambda_0$ = 1,5 mm) et une absorption réduite à la longueur d'onde radiative.

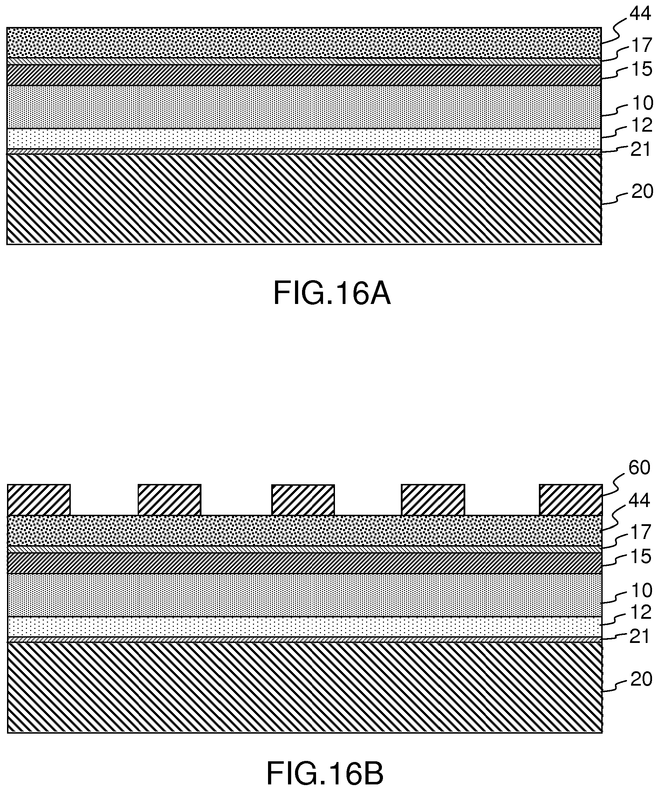

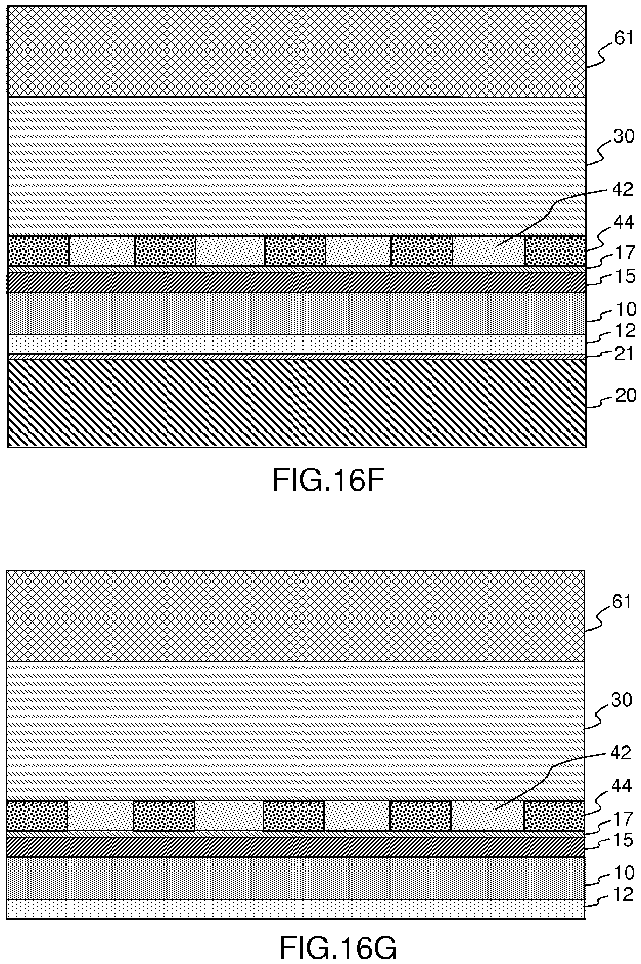

Les figures 16A à 16G illustrent un exemple de réalisation pour la fabrication d'un élément de détection selon la présente description, adaptées par exemple à des couches en matériau semi-conducteur mono cristallin.

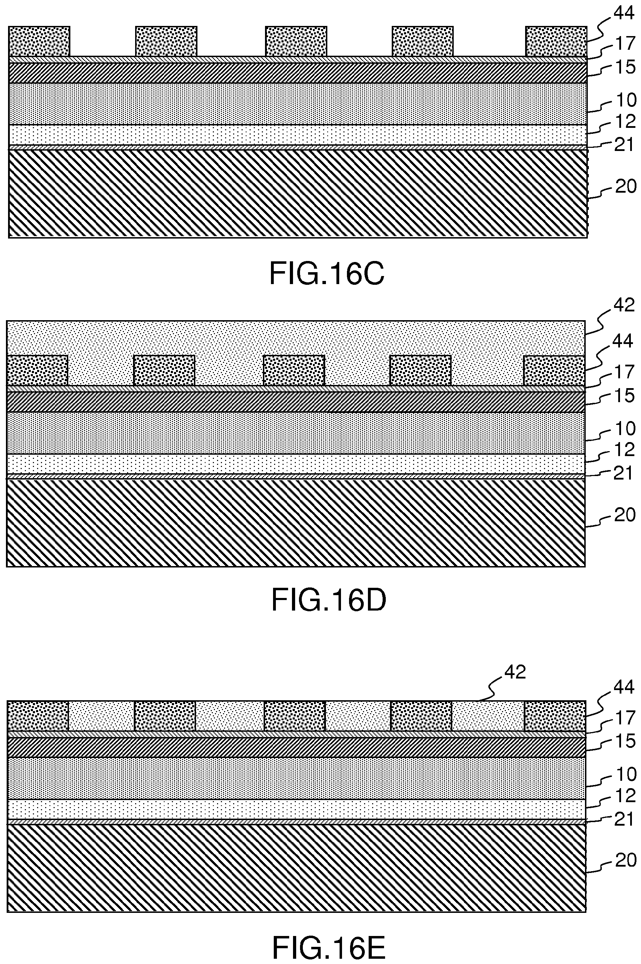

Dans une première étape (figure 16A), on réalise par épitaxie sur un substrat 20 adapté (par exemple en InP) un empilement de couches 21, 12, 10, 15, 17 et 44 en matériau semi-conducteur (par exemple, alternativement GaInAs et InP). Une première couche d'arrêt 21 (par exemple en InGaAs) est épitaxiée sur le substrat InP. Les couches 15, 10 et 19 sont adaptées à la réalisation de l'élément détecteur recherché. Il s'agit respectivement d'une couche 15 en InP dopée N, d'une couche 10 intrinsèque et d'une couche 19 dopée P pour former une jonction PIN. La zone Intrinsèque peut avoir des dimensions typiquement de 70 nm. La couche 19 de dopage N peut avoir des dimensions typiquement de 200 nm avec un dopage au carbone de typiquement $3\times10^{18}$ cm$^{-3}$. La couche de dopage n 15 peut avoir des dimensions typiquement de 200 nm avec un dopage au silicium de typiquement $3\times10^{18}$ cm$^{-3}$. Dans une deuxième étape (figure 16B), il est procédé à la création d'un masque 60 par lithographie sur la couche d'InP 44. Ce masque permet notamment de définir la forme des réseaux de couplage. Dans une troisième étape (figure 16C), la couche d'InP est gravée par gravure ionique réactive et par gravure humide. La couche d'InGaAs sert alors de couche d'arrêt pour la gravure. Puis, il est procédé au retrait du masque. Dans une quatrième étape (figure 16D), il est procédé à l'enduction de la résine planarisante 42 (diélectrique) à la tournette. Dans une cinquième étape (figure 16E), il est procédé à une gravure ionique réactive du diélectrique jusqu'à effleurement. Dans une sixième étape (figure 16F), il est procédé au dépôt d'une couche métallique 30 en Au. Dans une septième étape l'échantillon est reporté sur un substrat hôte par une méthode de collage (époxy, collage anodique...). Enfin, dans une huitième étape, il est procédé au retrait du substrat 2 jusqu'à la couche d'arrêt 21 puis retrait de cette dernière par voie humide. Il est possible, pour protéger le dispositif contre les agressions extérieures (hybridation, atmosphère sur le long terme) et pour réduire les effets de vieillissement, de procéder à une dernière étape d'encapsulation par le dépôt d'une résine en dehors des zones métallisées.

Les couches en matériau semi-conducteur monocristallin épitaxiées telles que décrites dans le procédé ci-dessus peuvent comprendre par exemple des couches en arséniure de gallium (GaAs) et les alliages associés (par exemple l'arséniure d'aluminium et de gallium AlGaAs), des couches en phosphure d'indium InP et les alliages associés (par exemple l'arséniure de gallium et d'indium InGaAs), des couches en antimoniure de gallium (GaSb) et en arséniure d'indium (InAs), en particulier un super-réseau InAs/GaSb et les alliages associés (par exemple l'antimoniure de gallium et d'aluminium AlGaSb), des couches en silicium (Si).

Le même procédé peut s'appliquer pour la réalisation d'autres hétérojonctions adaptées à la détection dans d'autres bandes spectrales. Par exemple :

- InAlAs/InGaAs à $\lambda \approx 15$ $\mu$m;
- AlGaAs/GaAs à $\lambda \approx 0.9$ $\mu$m;
- GaInP/GaAs à $\lambda \approx 0.9$ $\mu$m;
- [SR InAs/AlSb] / [SR InAs/GaSb] dans la bande 3-5 $\mu$m;
- HgCdTe/HgCdTe dans les bandes 3-5 $\mu$m et 8-12 $\mu$m ;
- InP et InAlAs/GaAsSb à $\lambda \approx 1.5$ $\mu$m.

Bien que décrite principalement dans le cadre de détecteurs dans l'infrarouge, l'invention s'applique de la même manière à la détection dans le visible, notamment pour des applications photovoltaïques. Les éléments de photodétection adaptés à la réalisation d'un dispositif sont sensiblement les mêmes que ceux décrits pour la détection, mais ils sont polarisés en direct. En effet, le rendement de conversion de l'énergie solaire en énergie électrique est limité par plusieurs facteurs, dont les recombinaisons radiatives des photoporteurs. Selon l'article (Polman, A., & Atwater, H. A. (2012). Photonic design principles for ultrahigh-efficiency photovoltaics. Nature materials, 11(3), 174-177), On gagnerait ainsi environ 7% sur le rendement des cellules solaires en s'affranchissant de ces recombinaisons.

Bien que décrite à travers un certain nombre d'exemples de réalisation détaillés, l'élément de détection quantique et la méthode de fabrication dudit élément comprennent différentes variantes, modifications et perfectionnements qui apparaîtront de façon évidente à l'homme de l'art.

## Revendications

1. Elément de photodétection quantique ($P_1$, $P_2$, ...) d'un rayonnement incident dans une bande spectrale centrée autour d'une longueur d'onde centrale $\lambda_0$, présentant une face avant (FF) destinée à recevoir ledit rayonnement, et comprenant :

   - un empilement de couches en matériau semi-conducteur formant une jonction PN ou PIN et comprenant au moins une couche en matériau semi-conducteur absorbant (10) de longueur d'onde de coupure $\lambda_c > \lambda_0$, l'empilement de couches en matériau semi-conducteur formant une cavité optique résonante (2) de type guide d'onde d'épaisseur (e) donnée ;
   - une couche réflective métallique (30) agencée d'un côté de la cavité optique, opposé au côté supportant la face avant, formant un miroir optique ; et
   - une structure de couplage (4) du rayonnement incident avec la cavité optique, formé d'un réseau de diffraction en face avant et/ou d'un réseau de diffraction en face arrière, c'est-à-dire d'un côté de la cavité optique opposé au côté supportant la face avant,

   charactérisé en ce que ledit réseau est formé d'une alternance de deux matériaux diélectriques et présente une épaisseur ($h_C$) une période (p) et un facteur de remplissage (w/p) donnés, déterminés pour former :

   ○ une résonance de modes guidés à la longueur d'onde centrale $\lambda_0$ permettant une absorption supérieure à 80% dans la couche en matériau semi-conducteur absorbant à ladite longueur d'onde centrale;
   ○ une antirésonance à la longueur d'onde radiative $\lambda_{rad}$ dans la couche de matériau semi-conducteur absorbant de façon à produire un minimum d'absorption dans la couche en matériau semi-conducteur absorbant à la longueur d'onde radiative $\lambda_{rad}$, où la longueur d'onde radiative $\lambda_{rad}$ est la longueur d'onde pour laquelle, à température de fonctionnement, le taux de recombinaison radiative est maximal.

2. Elément de photodétection selon la revendication 1, dans lequel la résonance à la longueur d'onde centrale $\lambda_0$ est localisée dans la couche en matériau semi-conducteur absorbant.

3. Elément de photodétection selon l'une quelconque des revendications précédentes, dans lequel la structure de couplage du rayonnement incident avec la cavité optique est adapté pour réduire l'absorption dans la couche en matériau semi-conducteur absorbant à la longueur d'onde radiative $\lambda_{rad}$, la dite réduction étant supérieure à $\exp(\Delta E/kT)$ où $\Delta E$ est la variation des énergies correspondant aux longueurs d'onde $\lambda_{rad}$ et $\lambda_o$.

4. Elément de photodétection selon l'une quelconque des revendications précédentes, dans lequel la structure de couplage comprend un réseau de diffraction en face arrière, c'est-à-dire d'un côté de la cavité optique, opposé au côté supportant la face avant.

5. Elément de photodétection selon l'une quelconque des revendications précédentes, dans lequel l'épaisseur du guide d'onde est comprise entre $\lambda_0/8n$ et $\lambda_0/n$, avantageusement entre $\lambda_0/4n$ et $3\lambda_0/4n$, où n est la valeur moyenne des parties réelles des indices de réfraction de la ou des couche(s) en matériau semi-conducteur formant le guide d'onde.

6. Elément de photodétection selon l'une quelconque des revendications précédentes, dans lequel le ou les réseau(x) de diffraction comprennent une structure périodique, de période comprise entre $\lambda_0/n$ et $\lambda_0/n_1$, où n est la valeur moyenne des parties réelles des indices de réfraction de la ou des couche(s) en matériau semi-conducteur formant le guide d'onde et $n_1$ est la partie réelle de l'indice de réfraction du milieu d'incidence du rayonnement.

7. Elément de photodétection selon l'une quelconque des revendications précédentes, comprenant un empilement de couches en matériau semi-conducteur formant une hétérojonction de type PN ou PIN, ledit empilement comprenant la ou les couche(s) en matériau semi-conducteur formant la cavité optique.

8. Elément de photodétection selon la revendication 7, dans lequel l'hétérojonction comprend des couches barrière (12, 14).

9. Elément de photodétection selon la revendication 8, dans lequel l'une au moins des couches barrière (14) est structurée sur au moins une partie de son épaisseur pour former un réseau de diffraction avec la cavité optique.

10. Elément de photodétection selon l'une quelconque des revendications précédentes, adapté pour une détection dans l'une des bandes I, II ou III de l'infrarouge.

11. Détecteur infrarouge comprenant un assemblage d'éléments de photodétection quantique selon l'une quelconque des revendications précédentes.

12. Méthode de fabrication d'un élément de détection quantique selon l'une quelconque des revendications 1 à 10, comprenant :

- La formation sur un substrat (20) d'une structure épitaxiée, comprenant un empilement de couches en matériau semi-conducteur, dont au moins une couche en matériau semi-conducteur absorbant (10) de longueur d'onde de coupure $\lambda_c> \lambda_0$, et une couche supérieure en matériau diélectrique (44),
- La structuration de la couche supérieure en matériau diélectrique pour former un réseau de diffraction,
- Le dépôt sur ledit réseau de diffraction d'une couche réflective métallique (30),
- Le retrait du substrat pour former la face avant (FF) de l'élément de détection.

13. Méthode de fabrication selon la revendication 12, dans laquelle la formation de la structure épitaxiée comprend une épitaxie par voie organométallique.

**Patentansprüche**

1. Quantenphotodetektionselement ($P_1$, $P_2$, ...) einer einfallenden Strahlung in einem Spektralband, das um eine zentrale Wellenlänge $\lambda_0$ zentriert ist, mit einer Frontseite (FF), die zum Empfangen der Strahlung bestimmt ist, und das Folgendes umfasst:

- einen Stapel von Schichten aus Halbleitermaterial, der einen PN- oder PIN-Übergang bildet und mindestens eine Schicht aus absorbierendem Halbleitermaterial (10) mit einer Grenzwellenlänge $\lambda_c>\lambda_0$ umfasst, wobei der Stapel von Schichten aus Halbleitermaterial einen optischen Resonanzhohlraum (2) des Wellenleitertyps mit einer gegebenen Dicke (e) bildet;
- eine metallische Reflexionsschicht (30), die auf einer Seite des optischen Hohlraums gegenüber der die Frontseite tragenden Seite angeordnet ist und einen optischen Spiegel bildet; und
- eine Struktur (4) zum Koppeln der einfallenden Strahlung mit dem optischen Hohlraum, gebildet aus einem Frontseitenbeugungsgitter und/oder einem Rückseitenbeugungsgitter, d.h. auf einer Seite des optischen Hohlraums gegenüber der die Frontseite tragenden Seite,

**dadurch gekennzeichnet, dass** das Netzwerk aus zwei abwechselnden dielektrischen Materialien gebildet wird und eine(n) gegebene(n) Dicke ($h_c$), Periode (p) und Füllfaktor (w/p) aufweist, bestimmt zum Bilden:

◦ einer Geführten-Moden-Resonanz bei der zentralen Wellenlänge $\lambda_0$, die eine Absorption von mehr als 80 % in der Schicht aus dem absorbierenden Halbleitermaterial bei der zentralen Wellenlänge zulässt;
◦ einer Antiresonanz bei der Strahlungswellenlänge $\lambda_{rad}$ in der absorbierenden Halbleitermaterialschicht, um ein Absorptionsminimum in der absorbierenden Halbleitermaterialschicht bei der Strahlungswellenlänge $\lambda_{rad}$ zu erzeugen, worin die Strahlungswellenlänge $\lambda_{rad}$ die Wellenlänge ist, für die bei Betriebstemperatur die Strahlungsrekombinationsrate maximal ist.

2. Photodetektionselement nach Anspruch 1, wobei sich die Resonanz bei der zentralen Wellenlänge $\lambda_0$ in der Schicht aus absorbierendem Halbleitermaterial befindet.

3. Photodetektionselement nach einem der vorherigen Ansprüche, wobei die Kopplungsstruktur der einfallenden Strahlung mit dem optischen Hohlraum zum Verringern der Absorption in der absorbierenden Halbleitermaterialschicht bei der Strahlungswellenlänge $\lambda_{rad}$ angepasst ist, wobei die Verringerung größer als $\exp(\Delta E/kT)$ ist, worin $\Delta E$ die Variation der Energien entsprechend den Wellenlängen $\lambda_{rad}$ und $\lambda_0$ ist.

4. Photodetektionselement nach einem der vorherigen Ansprüche, wobei die Kopplungsstruktur ein Beugungsgitter auf der Rückseite, d.h. auf einer Seite des optischen Hohlraums gegenüber der die Frontseite tragenden Seite umfasst.

5. Photodetektionselement nach einem der vorherigen Ansprüche, wobei die Dicke des Wellenleiters zwischen $\lambda_0/8n$ und $\lambda_0/n$, vorzugsweise zwischen $\lambda_0/4n$ und $3\lambda_0/4n$ liegt, worin n der Mittelwert der Realteile der Brechungsindizes der den Wellenleiter bildenden Halbleitermaterialschicht(en) ist.

6. Photodetektionselement nach einem der vorherigen Ansprüche, wobei das/die Beugungsgitter eine periodische Struktur mit einer Periode zwischen $\lambda_0/n$ und $\lambda_0/n_1$ umfasst/umfassen, worin n der Mittelwert der Realteile der Brechungsindizes der den Wellenleiter bildenden Halbleitermaterialschicht(en) ist und $n_1$ der Realteil des Brechungsindexes des einfallenden Mediums der Strahlung ist.

7. Photodetektionselement nach einem der vorherigen Ansprüche, das einen Stapel von Halbleitermaterialschichten umfasst, die einen Heteroübergang vom PN- oder PIN-Typ bilden, wobei der Stapel die den optischen Hohlraum bildenden Halbleitermaterialschicht(en) umfasst.

8. Photodetektionselement nach Anspruch 7, wobei der Heteroübergang Sperrschichten (12, 14) umfasst.

9. Photodetektionselement nach Anspruch 8, wobei mindestens eine der Sperrschichten (14) über mindestens einen Teil ihrer Dicke so strukturiert ist, dass sie mit dem optischen Hohlraum ein Beugungsgitter bildet.

10. Photodetektionselement nach einem der vorherigen Ansprüche, angepasst zum Detektieren in einem der Infrarotbänder I, II oder III.

11. Infrarotdetektor mit einer Anordnung von Quantenphotodetektionselementen nach einem der vorherigen Ansprüche.

12. Verfahren zur Herstellung eines Quantendetektionselements nach einem der Ansprüche 1 bis 10, das Folgendes umfasst:

- Bilden einer epitaxierten Struktur auf einem Substrat (20), die einen Stapel von Halbleitermaterialschichten, darunter mindestens eine Schicht aus absorbierendem Halbleitermaterial (10) mit einer Grenzwellenlänge $\lambda_c > \lambda_0$, und eine obere Schicht aus dielektrischem Material (44) umfasst,
- Strukturieren der oberen Schicht aus dielektrischem Material zum Bilden eines Beugungsgitters,
- Absetzen einer metallischen Reflexionsschicht (30) auf dem Beugungsgitter,
- Entfernen des Substrats, um die Frontfläche (FF) des Detektionselements zu bilden.

13. Herstellungsverfahren nach Anspruch 12, wobei die Bildung der epitaxierten Struktur metallorganische Epitaxie umfasst.

**Claims**

1. A quantum photodetection element ($P_1$, $P_2$,...) for an incident radiation in a spectral band centered around a central wavelength $\lambda_0$, exhibiting a front face (FF) intended to receive said radiation, and comprising:

   - a stack of layers made of semi-conducting material forming a PN or PIN junction and comprising at least one layer made of an absorbent semi-conducting material (10) with a cutoff wavelength $\lambda_c > \lambda_0$, the stack of layers made of semi-conducting material forming a resonant optical cavity (2) of waveguide type with a given thickness (e);
   - a metallic reflective layer (30) arranged on a side of the optical cavity, opposite to the side supporting the front face, forming an optical mirror; and
   - a structure for coupling (4) the incident radiation with the optical cavity, formed of a diffraction grating on the front face and/or a diffraction grating on the rear face, that is to say on a side of the optical cavity, opposite to the side supporting the front face,
   **characterized in that** said grating consists of an alternation of two dielectric materials and has a given thickness ($h_c$), period (p) and fill factor (w/p), configured to form one of the following:

      ◦ a guided-mode resonance at the central wavelength $\lambda_0$, allowing an absorption greater than 80% in the absorbent semi-conducting material layer at said central wavelength;
      ◦ an antiresonance at the radiative wavelength $\lambda_{rad}$ in the absorbent semi-conducting material layer so as to produce a minimum of absorption in the absorbing semi-conduction material layer at the radiative wavelength $\lambda_{rad}$, where the radiative wavelength $\lambda_{rad}$ is the wavelength for which, at operating temperature, the rate of radiative recombination is a maximum.

2. The photodetection element according to claim 1, wherein the resonance at the central wavelength $\lambda_0$ is located in the absorbent semi-conducting material layer.

3. The photodetection element according to one of the preceding claims, wherein the structure for coupling the incident radiation with the optical cavity is suitable for reducing the absorption in the absorbent semi-conducting material layer at the radiative wavelength $\lambda_{rad}$, said reduction being greater than $\exp(\Delta E/kT)$ where $\Delta E$ is the variation of the energies corresponding to the wavelengths $\lambda_{rad}$ and $\lambda_0$.

4. The photodetection element according to one of the preceding claims, wherein the structure for coupling comprises a diffraction grating on the rear side, that is to say on a side of the optical cavity, opposite to the side supporting the front face.

5. The photodetection element according to one of the preceding claims, wherein the thickness of the waveguide lies between $\lambda_0/8n$ and $\lambda_0/n$, advantageously between $\lambda_0/4n$ and $3\lambda_0/4n$, where n is the average value of the real parts of the refractive indices of the layer(s) made of semi-conducting material forming the waveguide.

6. The photodetection element according to one of the preceding claims, wherein the coupling grating(s) comprise(s) a periodic structure, of period lying between $\lambda_0/n$ and $\lambda_0/n_1$ where n is the average value of the real parts of the refractive indices of the layer(s) made of semi-conducting material forming the waveguide and $n_1$ is the real part of the refractive index of the medium of incidence of the radiation.

7. The photodetection element according to one of the preceding claims, comprising a stack of layers made of semi-conducting material forming a heterojunction of PN or PIN type, said stack comprising the layer(s) made of semi-conducting material forming the optical cavity.

8. The photodetection according to claim 7, wherein the heterojunction comprises barrier layers (12, 14).

9. The photodetection element according to claim 8, wherein at least one of the barrier layers (14) is structured on at least one part of its thickness so as to form a diffraction grating with the optical cavity.

**10.** The photodetection element according to one of the preceding claims, suitable for detection in one of infrared bands I, II or III.

**11.** An infrared detector comprising an assemblage of quantum photodetection elements according to one of the preceding claims.

**12.** A method for manufacturing a quantum detection element according to one of claims 1 to 10, comprising:

- formation on a substrate (20) of an epitaxied structure, comprising a stack of layers made of semi-conducting material, including at least one layer made of absorbent semi-conducting material (10) with a cutoff wavelength $\lambda_c > \lambda_0$ and an upper layer made of dielectric material (44);
- structuring the upper layer made of dielectric material to form a diffraction grating;
- deposition on said diffraction grating of a metallic reflective layer (30);
- removal of the substrate to form the front face (FF) of the detection element.

**13.** The manufacturing method according to claim 12, wherein the formation of the epitaxied structure comprises an epitaxy by an organometallic procedure.

Energie

Bande de conduction

Niveau de Fermi

$E_F$

Bande interdite

Bande de valence

Distance

Type P　　　ZCE　　　Type N

## FIG.1A
## ART ANTERIEUR

Eclairement E

I

V

I

0

P>0

V

P>0

P<0

$E_1$

$E_2 > E_1$

$E_3 > E_1$

## FIG.1B
## ART ANTERIEUR

Pixel 1    Pixel 2

InP    p+    p+    — 14

— 16

— 1

InGaAs    — 10

InP    n+    — 12

— 8

FF

# FIG.2
## ART ANTERIEUR

FIG.3A

FIG.3B

FIG.4A          FIG.4B          FIG.4C

FIG.5A

FIG.5B

44   42

FIG.5C

44                    42

FIG.5D

42

44

FIG.5E

FIG.6

FIG.7

FIG.8

FIG.10

FIG.9A

FIG.9B

FIG.9C

FIG.9D

FIG.11

FIG.12

FIG.13A

FIG.13B

FIG.14

FIG.15

FIG.16A

FIG.16B

FIG.16C

FIG.16D

FIG.16E

FIG.16F

FIG.16G

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2276072 A
- EP 0807982 A
- EP 2477231 A
- FR 2959352

**Littérature non-brevet citée dans la description**

- **S.R. FORREST et al.** In0,53Ga0,47As photodiodes with dark current limited by generation-recombination and tunneling. *Appl.Phys.Lett.,* 1980, vol. 37 (3
- **J. A. TREZZA et al.** *Proceedings SPIE,* 2011, vol. 8012, 80121Y-80121Y, 12
- **POLMAN, A. ; ATWATER, H. A.** Photonic design principles for ultrahigh-efficiency photovoltaics. *Nature materials,* 2012, vol. 11 (3), 174-177
- *Journal of Applied Physics,* 1989, vol. 66 (12), 6030-6040
- **ALEKSANDAR D. RAKIC ; ALEKSANDRA B. DJURIŠIC ; JOVAN M. ELAZAR ; MARIAN L. MAJEWSKI.** Optical properties of metallic films for vertical-cavity optoelectronic devices. *Applied Optics,* 1998, vol. 37 (22), 5271-5283
- **P.BOUCHON et al.** Fast modal method for subwavelength gratings based on B-spline formulation. *Journal of the Optical Society of America A,* 2010, vol. 27 (4), 696-702